(19) Europäisches Patentamt
European Patent Office
Office européen des brevets

(11) EP 4 122 998 A2

(12) EUROPEAN PATENT APPLICATION

(43) Date of publication:
**25.01.2023 Bulletin 2023/04**

(21) Application number: **22186479.6**

(22) Date of filing: **22.07.2022**

(51) International Patent Classification (IPC):
***C09K 11/02*** $^{(2006.01)}$ ***C09K 11/56*** $^{(2006.01)}$
***C09K 11/70*** $^{(2006.01)}$ ***C09K 11/88*** $^{(2006.01)}$
***H05B 33/14*** $^{(2006.01)}$

(52) Cooperative Patent Classification (CPC):
**C09K 11/02; C09K 11/025; C09K 11/565; C09K 11/70; C09K 11/883; H05B 33/14**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.07.2021 KR 20210096367**

(71) Applicant: **Samsung Electronics Co., Ltd.**
**Gyeonggi-do, 16677 (KR)**

(72) Inventors:
- **KIM, Tae Gon**
  **Hwaseong-si (KR)**
- **PARK, Shang Hyeun**
  **Yongin-si (KR)**
- **JUN, Shin Ae**
  **Seongnam-si (KR)**
- **KIM, Taekhoon**
  **Hwaseong-si (KR)**
- **PARK, Garam**
  **Songpa-gu (KR)**
- **WON, Nayoun**
  **Yongin-si (KR)**

(74) Representative: **Elkington and Fife LLP**
**Prospect House**
**8 Pembroke Road**
**Sevenoaks, Kent TN13 1XR (GB)**

# (54) QUANTUM DOT, QUANTUM DOT COMPOSITE, DISPLAY PANEL, AND ELECTRONIC DEVICE INCLUDING THE SAME

(57) A quantum dot, a quantum dot composite including the quantum dot, a display panel including the quantum dot composite, and an electronic device including the display panel are provided. The quantum dot includes indium, zinc, phosphorus, and selenium, and does not include cadmium, and has an optical density (OD) per 1 mg for a wavelength of 450 nm of from about 0.2 to about 0.3 and an emission peak of from about 500 nm to about 550 nm, or an optical density per 1 mg for a wavelength of about 450 nm of from about 0.5 to about 0.7 and an emission peak of from about 610 nm to about 660 nm.

FIG. 8

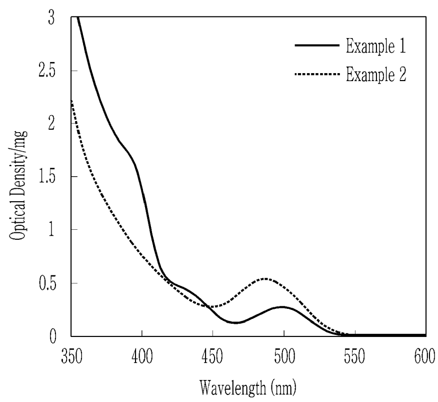


EP 4 122 998 A2

## Description

### FIELD OF THE INVENTION

A quantum dot, a quantum dot composite, a display panel including the quantum dot composite, and an electronic device are disclosed.

### BACKGROUND OF THE INVENTION

Quantum dots are nano-sized semiconductor nanocrystal materials, and their optical properties, for example, luminous properties can be controlled, for example, by changing the size and/or composition of the quantum dots. The luminous properties of quantum dots may be applied to an electronic device, for example, a display device. When applied in an electronic or display device, the quantum dots may be applied in the form of a composite including the quantum dots. There are needs for the development of quantum dots and quantum dot composites that are environmentally friendly and capable of exhibiting improved optical and/or physical properties.

### SUMMARY OF THE INVENTION

An embodiment provides a quantum dot capable of exhibiting improved luminous properties and driving reliability (e.g., when applied to a device in the form of a composite) and a quantum dot composite including the quantum dot.
Another embodiment provides a display panel including the quantum dot composite.
Another embodiment relates to an electronic device (e.g., a display device) including the display panel.
A quantum dot according to an embodiment includes indium, zinc, phosphorus, and selenium, and does not include cadmium, wherein the quantum dot has an optical density (OD) per 1 mg at a wavelength of 450 nm in a range of about 0.2 (e.g., greater than or equal to about 0.22 or greater than or equal to about 0.222) to about 0.27 (e.g., less than or equal to about 0.269) , and an emission peak between about 500 nm to about 550 nm, or an optical density per 1 mg at a wavelength of about 450 nm in a range of about 0.5 to about 0.7 and an emission peak between about 610 nm to about 660 nm.
In an embodiment, a display panel include the quantum dots described herein (e.g., first quantum dots and second quantum dots). In an embodiment, the display panel includes a quantum dot composite including a matrix, and a plurality of (cadmium-free) quantum dots, wherein the plurality of quantum dots includes a metal element including indium and zinc, a non-metal element including phosphorus and selenium, and optionally, sulfur, and

> wherein the plurality of quantum dots includes first quantum dot(s) and second quantum dot(s),
> wherein the first quantum dot(s) has (have) or exhibits (exhibit) an optical density (OD) per 1 mg at a wavelength of 450 nm in a range of about 0.2 (or greater than or equal to about 0.22, or about 0.222 or about 0.225 or greater) to about 0.27 (or less than or equal to about 0.269), and an emission peak between about 500 nm to about 550 nm,
> wherein the second quantum dot(s) has (have) or exhibit(s) an optical density per 1 mg at a wavelength of about 450 nm in a range of about 0.5 to about 0.7 and an emission peak between about 610 nm to about 660 nm.

The display panel may include or may not include a liquid crystal layer.
In an embodiment, the first quantum dots and the second quantum dots may be included in a first color conversion region and a second color conversion region, respectively, in a color conversion layer. The first quantum dots may be included in the first color conversion region and the second quantum dots may be included in the second color conversion region. The first color conversion region and the second color conversion region may be spaced apart (or be separated) each other, for example, by a partition wall.
The (first) quantum dot may have an optical density per 1 mg for a wavelength of about 460 nm in a range of about 0.12 to about 0.35, and an emission peak of from about 500 nm (or about 530 nm) to about 550 nm (or to about 540 nm).
The (second) quantum dot may have an optical density per 1 mg for a wavelength of about 460 nm in a range of about 0.4 to about 0.5, and an emission peak of from about 610 nm (or about 635 nm) to about 660 nm (or to about 645 nm).
The quantum dots (e.g., the first quantum dots and/or the second quantum dots) may include a semiconductor nanocrystal core including indium and phosphorus, and a semiconductor nanocrystal shell disposed on the semiconductor nanocrystal core, the nanocrystal shell including zinc and selenium.
The semiconductor nanocrystal shell may further include sulfur.
The semiconductor nanocrystal shell may include a first semiconductor nanocrystal shell disposed on the semiconductor nanocrystal core, the first nanocrystal shell including zinc and selenium, and may further include a second

semiconductor nanocrystal shell disposed on the first semiconductor nanocrystal shell, the second nanocrystal shell including zinc and sulfur.

In the plurality of quantum dots (or in the first quantum dots and/or the second quantum dots), a weight ratio of zinc to indium (Zn/In) may be greater than or equal to about 10 and less than or equal to about 30, and a weight ratio of selenium to indium (Se/In) may be greater than or equal to about 2.9 and less than or equal to about 20.

A display panel according to an embodiment includes (a color conversion layer including) a quantum dot composite(s) including a matrix, and a plurality of quantum dots and titanium dioxide ($TiO_2$) dispersed in the matrix, wherein the plurality of quantum dots includes indium, zinc, phosphorus, and selenium, and optionally, sulfur, and wherein the display panel has (for example, in the color conversion layer or in the color conversion regions and the light transmitting region) a weight ratio of indium to titanium (In/Ti) that is greater than or equal to about 0.1 and less than or equal to about 0.7, a weight ratio of phosphorus to titanium (P/Ti) that is greater than or equal to about 0.05 and less than or equal to about 0.2.

In an embodiment, the display panel may have (for example, in the color conversion layer or in the color conversion regions and the light transmitting region) a weight ratio of selenium to titanium (Se/Ti) that is greater than or equal to about 0.5 and less than or equal to about 3.

The plurality of quantum dots may include the first quantum dots and the second quantum dots.

In an embodiment, the display panel may have (for example, in the color conversion layer or in the color conversion regions and the light transmitting region) a weight ratio of indium to titanium (In/Ti) that is less than or equal to about 0.5.

In an embodiment, the display panel may have (for example, in the color conversion layer or in the color conversion regions and the light transmitting region) a weight ratio of phosphorus to titanium (P/Ti) that is less than or equal to about 0.15.

The display panel may include a color conversion layer including a plurality of regions including a color conversion region, and the quantum dot composite may be disposed in the color conversion region. In an embodiment, a color conversion layer includes the quantum dots or the quantum dot composite described herein.

The display panel may further include a light emitting panel including a light emitting source configured to emit blue light, a light emitting source configured to emit green light, or a combination thereof, wherein the color conversion layer may include a first color conversion region configured to convert blue light and/or green light emitted from the light emitting panel into light of a first emission spectrum, a second color conversion region configured to convert blue light and/or green light emitted from the light emitting panel into light of a second emission spectrum, or a combination thereof.

The plurality of regions of the color conversion layer may further include a light transmitting region configured to transmit blue light and/or green light emitted from the light emitting panel.

The first emission spectrum may be a green emission spectrum having an emission peak wavelength between about 500 nm and about 550 nm, and in the first color conversion region, a weight ratio of selenium to titanium (Se/Ti) may be greater than or equal to about 2 and less than or equal to about 12.

In the first color conversion region, a weight ratio of indium to titanium (In/Ti) may be greater than or equal to about 0.2 and less than or equal to about 1.8. and a weight ratio of phosphorus to titanium (P/Ti) may be greater than or equal to about 0.05 and less than or equal to about 0.4.

The second emission spectrum may be a red emission spectrum having an emission peak wavelength between about 610 nm and about 660 nm, and a weight ratio of selenium to titanium (Se/Ti) in the second color conversion region may be greater than or equal to about 1 and less than or equal to about 5.

In the second color conversion region, a weight ratio of indium to titanium (In/Ti) may be greater than or equal to about 0.1 and less than or equal to about 0.5, and a weight ratio of phosphorous to titanium (P/Ti) may be greater than or equal to about 0.05 and less than or equal to about 0.3.

In the first color conversion region, a weight ratio of indium to titanium (In/Ti) may be greater than or equal to about 0.2 and less than or equal to about 1.5, a ratio weight of phosphorous to titanium (P/Ti) may be greater than or equal to about 0.1 and less than or equal to about 0.3, and a weight ratio of selenium to titanium (Se/Ti) may be greater than or equal to about 3 and less than or equal to about 10.

In the second color conversion region, a ratio weight of indium to titanium (In/Ti) may be greater than or equal to about 0.2 and less than or equal to about 0.4, a weight of phosphorous to titanium (P/Ti) may be greater than or equal to about 0.1 and less than or equal to about 0.3, and a weight ratio of selenium to titanium (Se/Ti) may be greater than or equal to about 1.2 and less than or equal to about 3.

The plurality of quantum dots includes a semiconductor nanocrystal core including indium and phosphorus, and a semiconductor nanocrystal shell disposed on the semiconductor nanocrystal core, the nanocrystal shell including zinc and selenium, and optionally sulfur.

The matrix may include a polymerizable monomer having a carbon-carbon double bond, an organic solvent, a polymer, a thiol compound having at least one thiol group at the terminal end, or a combination thereof.

An electronic device according to another embodiment includes the display panel.

The quantum dots according to an embodiment form a composite with a matrix including the quantum dots may exhibit improved optical properties, for example, an increased blue light absorption rate, and/or improved green light or red light conversion efficiency according to the increased blue light absorption rate. Accordingly, the quantum dot composite according to an embodiment may be advantageously applied to various display devices, and, for example, biological labeling, for example, a biosensor or bioimaging, a photodetector, a solar cell, a hybrid composite, and the like.

## BRIEF DESCRIPTION OF THE DRAWINGS

FIG. 1A schematically shows a pattern forming process using a composition for producing a quantum dot composite according to an embodiment.
FIG. 1B schematically shows a pattern forming process using an ink composition as a form of a quantum dot composite according to an embodiment.
FIG. 2 is an exploded view of a display device according to an embodiment.
FIG. 3 is a perspective view illustrating an example of a display panel according to an embodiment.
FIG. 4 is a cross-sectional view of the display panel of FIG. 3.
FIG. 5 is a plan view illustrating an example of a pixel arrangement of the display panel of FIG. 3.
FIG. 6A is a cross-sectional view of the display panel of FIG. 3 taken along line IV-IV.
FIG. 6B is a cross-sectional view of a display panel according to another embodiment.
FIG. 7 is a schematic cross-sectional view of a display device according to an embodiment.
FIG. 8 is a graph showing the optical density for each wavelength per 1 mg of quantum dots prepared in Examples 1 and 2.

## DETAILED DESCRIPTION OF THE EMBODIMENTS

Advantages and characteristics of this disclosure, and a method for achieving the same, will become evident referring to the following embodiments together with the attached drawings. This invention may, however, be embodied in many different forms, and should not be construed as being limited to the embodiments set forth herein.

If not defined otherwise, all terms (including technical and scientific terms) in the specification may be defined as commonly understood by one skilled in the art. The terms defined in a generally-used dictionary should be interpreted as having a meaning that is consistent with their meaning in the context of the relevant art and the present disclosure, and will not be interpreted in an idealized or overly formal sense unless expressly so defined herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Like reference numerals designate like elements throughout the specification.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein. It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

It will be understood that when an element such as a layer, film, region, or substrate is referred to as being "on" another element, it can be directly on the other element or intervening elements may also be present. In contrast, when an element is referred to as being "directly on" another element, there are no intervening elements present.

Hereinafter, as used herein, when a definition is not otherwise provided, "substituted" refers to replacement of hydrogen of a compound by a substituent selected from a C1 to C30 alkyl group, a C2 to C30 alkenyl group, a C2 to

C30 alkynyl group, a C6 to C30 aryl group, a C7 to C30 alkylaryl group, a C1 to C30 alkoxy group, a C1 to C30 heteroalkyl group, a C3 to C30 heteroalkylaryl group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group (-NRR' wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation, a sulfonic acid group ($-SO_3H$) or a salt thereof ($-SO_3M$, wherein M is an organic or inorganic cation), a phosphoric acid group ($-PO_3H_2$) or a salt thereof ($-PO_3MH$ or $-PO_3M_2$, wherein M is an organic or inorganic cation), or a combination thereof.

As used herein, "monovalent organic a functional group" refers to a C1 to C30 alkyl group, a C2 to C30 alkenyl group, a C2 to C30 alkynyl group, a C6 to C30 aryl group, a C7 to C30 alkylaryl group, a C1 to C30 alkoxy group, a C1 to C30 heteroalkyl group, a C3 to C30 heteroalkylaryl group, a C3 to C30 cycloalkyl group, a C3 to C15 cycloalkenyl group, a C6 to C30 cycloalkynyl group, or a C2 to C30 heterocycloalkyl group.

In addition, when a definition is not otherwise provided below, "hetero" means one including 1 to 3 heteroatoms selected from N, O, S, Si, or P.

As used herein, "alkylene group" is a linear or branched saturated aliphatic hydrocarbon group that optionally includes at least one substituent and has two or more valences. As used herein, "arylene group" may be a functional group that optionally includes at least one substituent and having two or more valences formed by removal of at least two hydrogens in at least one aromatic ring.

In addition, "aliphatic group" refers to a saturated or unsaturated linear or branched C1 to C30 group consisting of carbon and hydrogen, and "aromatic organic group" includes a C6 to C30 aryl group or a C2 to C30 heteroaryl group, and "alicyclic group" refers to a saturated or unsaturated C3 to C30 cyclic group consisting of carbon and hydrogen.

As used herein, the term "(meth)acrylate" refers to acrylate and/or methacrylate.

As used herein, "light conversion rate" is a ratio of the emission amount (G or R) (which is denoted as A) of the quantum dot composite to the amount of light (B-B') absorbed from the excitation light (e.g., blue light) (B) of the quantum dot composite. In addition, the "light conversion efficiency" is a ratio of the emission amount (G or R) of the quantum dot composite to the emission amount (B) of the excitation light. The total light amount (B) of excitation light is obtained by integrating a PL spectrum, the PL spectrum of the quantum dot composite film is measured, a light amount (G or R) in a green or red wavelength emitted from the quantum dot composite film and a light amount (B') of excitation light are obtained, and light conversion rate, light conversion efficiency, and blue light absorption rate are obtained by the following equations:

$$A/(B-B') \times 100 = \text{light conversion rate (\%)}$$

$$A/B \times 100 = \text{light conversion efficiency (\%)}$$

$$(B-B')/B \times 100 = \text{blue light absorption rate (\%) of a film}$$

As used herein, "dispersion" refers to dispersion wherein a dispersed phase is a solid and a continuous phase includes a liquid. The "dispersion" may include a colloidal dispersion wherein the dispersed phase has a dimension of greater than or equal to about 1 nanometer (nm), for example, greater than or equal to about 2 nm, greater than or equal to about 3 nm, or greater than or equal to about 4 nm and several micrometers (μm) or less, (e.g., about 2 μm or less or about 1 μm or less).

Herein, the term "quantum dots" refer to a nanostructure that exhibits quantum confinement or exciton confinement, such as semiconductor-based nanocrystals (particles), for example, luminescent nanostructure (e.g., capable of emitting light by energy excitation). As used herein, the term "quantum dots" are not limited in shapes thereof, unless otherwise defined.

Here, "a dimension (e.g., size, diameter, thickness, etc.)" may be an average dimension (e.g., size, diameter, thickness, etc.). Here, the "average" may be mean or median. The dimension may be a value obtained by electron microscopic analysis. The dimension may be a value calculated in consideration of the composition and optical properties (e.g., UV absorption wavelength) of the quantum dots.

Herein, "quantum efficiency (or quantum yield)" may be measured in a solution state or in a solid state (in a composite). In an embodiment, quantum efficiency (or quantum yield) is the ratio of photons emitted to photons absorbed by the nanostructure or population thereof. In an embodiment, quantum efficiency may be measured by any method.

For example, for fluorescence quantum yield or efficiency, there may be two methods: an absolute method and a relative method. In the absolute method, quantum efficiency is obtained by detecting the fluorescence of all samples through an integrating sphere. In the relative method, the quantum efficiency of the unknown sample is calculated by comparing the fluorescence intensity of a standard dye (standard sample) with the fluorescence intensity of the unknown sample. Coumarin 153, Coumarin 545, Rhodamine 101 inner salt, Anthracene and Rhodamine 6G may be used as standard dyes according to their PL wavelengths, but the present disclosure is not limited thereto.

The quantum efficiency (or quantum yield) may be easily and reproducibly determined using commercially available equipment from Hitachi or Hamamatsu, etc. and referring to manuals provided by, for example, respective equipment manufacturers.

The full width at half maximum (FWHM) and maximum emission (PL: photoluminescence) peak wavelength may be measured, for example, by an emission spectrum obtained by a spectrophotometer such as a fluorescence spectrophotometer or the like.

Herein, the term "does not include cadmium" (or other toxic heavy metals or given elements) means that a concentration of cadmium (or the corresponding heavy metals or given elements) is less than or equal to about 100 ppm, less than or equal to about 50 ppm, less than or equal to about 10 ppm, or near zero. In an embodiment, substantially no cadmium (or its heavy metal) is present, or, if present, in an amount below the detection limit of a given detection means or at an impurity level.

As used herein, the term "optical density" refers to an amount when light of a specific wavelength having a constant intensity passes through a solution and the luminous intensity becomes the constant intensity. In accordance with Beer-Lambert law, which will be described later, or a value divided by a thickness of the solution layer (optical path length) through which the wavelength has passed. In this specification, the absorbance at 450 nm of a quantum dot solution contained in a cuvette having a 1 cm optical path is defined as optical density.

The semiconductor nanocrystals, also called quantum dots, are crystalline semiconductor materials with nanoscale particle sizes. The quantum dots have a large surface area per unit volume, exhibits a quantum confinement effect, and may exhibit properties different from those of bulk materials having the same composition. The quantum dots may absorb light from an excitation source and reach an excited state, and upon relaxation emit energy corresponding to their energy bandgaps.

The quantum dots may be applied as light emitting materials in display devices. For example, the quantum dot composite (or referred to as quantum dot-polymer composite) including a plurality of quantum dots dispersed in a polymer matrix or the like may be used as a light conversion layer (e.g., a color conversion layer) that converts a light (e.g., blue light) from a light source (e.g., a backlight unit (BLU)) of a desired wavelength, for example, green light or red light in a display device. That is, unlike the conventional absorption type color filter, a patterned film including the quantum dot composite may be used as an emission type color filter. Since the emission type color filter is disposed in front of the display device, for example, when excitation light, which has linearity while passing through the liquid crystal layer, reaches the emission type color filter, it is scattered in all directions to realize a wider viewing angle, and light loss due to the absorption type color filter may be avoided. A display device including a quantum dot-based emission type color filter, for example, a liquid crystal display, may further include a polarizer inside the panel, for example, under the color filter. The display device may further include a yellow-recycling film (YRF) configured to recycle light and an excitation light blocker (e.g., a blue light-cut filter or a green light cut filter) according to an option.

The quantum dots having properties currently applicable to electronic devices and the like are mostly cadmium-based quantum dots. However, cadmium causes a serious environment/health problem and thus, is one of restricted elements. A cadmium-free quantum dot may be for example a Group III-V-based nanocrystal. However, cadmium-free quantum dots may have problems with low absorption of individual quantum dots so that the quantum dot color filter does not sufficiently absorb blue light and exhibits relatively low light conversion efficiency and a wide full width at half maximum of peak emission wavelength.

The absorption of blue light in a quantum dot color filter is basically based on a Beer-Lambert law, that is, $I = I_{0\ x}\ e^{-\alpha}$, wherein I is an intensity of the absorbed blue light and $I_0$ is an intensity of the blue light of the light emitting source and $\alpha = \varepsilon lc$, wherein $\varepsilon$ is a molar absorption coefficient of the quantum dot, l is the light travel distance, and c is a molar concentration of the quantum dot. Since quantum dots basically absorb blue light, the absorption coefficient ($\varepsilon$) of the quantum dots itself becomes the main variable for improving the absorption rate. The light travel distance (l) is a component determined by considering the thickness of the color filter and the optical path increased by the scattering body. In general, since quantum dots are added on a weight basis to implement color conversion pixels in a color filter, how high a concentration (c) quantum dots are contained per unit weight may also be an important variable in determining the absorption rate. Therefore, increase of the light absorption coefficient of the quantum dot, addition of a lot of scatterers or making the pixel thickness thick before the back-scattering effect becomes large, and increase of the number of quantum dot particles per the same weight, that is, increase of concentration of the quantum dots as much as possible may each factor into the absorption rate of blue light.

InP-based quantum dots are a material that does not contain heavy metals such as cadmium (Cd) or lead (Pb),

exhibits high quantum efficiency of over 90%, and may be mass-produced within acceptable specification. However, in the case of InP-based quantum dots, absorption of blue light occurs primarily in the core of InP and may be in-part from the shell, e.g., a ZnSe shell. In the instance of green light emission, a size of the core should be fixed so that there is little if any, possible way to increase the absorption coefficient of the quantum dot material in terms of the core structure. On the other hand, one may increase the density of a light scatterer or the thickness of a color conversion pixel, and when external light reflection or processability are considered, the scatterer may be added in an amount of about 3 weight percent (wt%) to about 4 wt% based on the total weight of the pixel. Moreover, it is also common to fix the thickness of the color conversion pixel to less than or equal to about 10 $\mu$m. Therefore, increasing the number of quantum dots per unit weight to increase the concentration of quantum dots inside the color conversion pixel may be technically feasible to increase the blue light absorption rate in the development of quantum dots.

The present inventors have considered a method of minimizing shell volume of a quantum dot, which may play an important role in increasing quantum efficiency, but does little or nothing to contribute to absorption of excitation light in quantum dots having a semiconductor nanocrystal core of indium and phosphorus (i.e., does not include cadmium) and a semiconductor nanocrystal shell including zinc and selenium and optionally sulfur, in order to reduce a weight of the quantum dots, and thus, increase the concentration of the quantum dots in a pixel. However, this is not a technically simple task because the making of a thinner shell should be realized without the consequence of a decrease in luminous efficiency.

In order to achieve this technical objective, the present inventors have confirmed that when the quantum dots, for example, include a first semiconductor nanocrystal shell including zinc and selenium and a second semiconductor nanocrystal shell including zinc and sulfur, light conversion efficiency and a blue light absorption rate of a quantum dot composite may be improved by, for example, reducing a thickness of the first semiconductor nanocrystal shell and/or the second semiconductor nanocrystal shell to a point by which the blue light absorption rate is increased with little, if any, reduction or decrease in light conversion efficiency, which, in turn, can allow for an increase in the number of the quantum dots per unit weight, from the observations of the results of the light conversion efficiency and blue light absorption rate of a quantum dot composite following curing (POB) in accordance with thicknesses of the first semiconductor nanocrystal shell including zinc and selenium and a second semiconductor nanocrystal shell including zinc and sulfur of the quantum dots included in the quantum dot composite. In addition, the inventors have confirmed that when quantum dots have a semiconductor nanocrystal core including indium and phosphorus and a semiconductor nanocrystal shell disposed on the core, the semiconductor nanocrystal shell including an alloy composition including zinc, selenium, and sulfur, the thickness of the shell may be reduced and still maintain a similar level of an energy barrier to the quantum dot having a first semiconductor nanocrystal shell including zinc and selenium and a second semiconductor nanocrystal shell including zinc and sulfur, thereby allowing for an increase in the number of the quantum dots per unit weight.

Accordingly, the two aforementioned quantum dots have reduced shell thickness, and thus, the respective weight of a quantum dot(s), and thus, the number of quantum dots per unit weight may be increased, that is, an increase in concentration of the quantum dots in a quantum dot composite is possible.

In an embodiment, the quantum dots as described herein may exhibit improved blue light absorption rate. In the embodiment, the quantum dots (the first quantum dots) may emit (e.g., are configured to emit) green light having an emission wavelength between about 500 nm to about 550 nm and may have or exhibit an optical density (OD) per 1 mg at a wavelength of 450 nm in a range of about 0.2 to 0.27 (0.22 to 0.269), and/or the quantum dots (the second quantum dots) may emit (or are configured to emit) red light having an emission wavelength between about 610 nm to about 660 nm and may have or exhibit an optical density (OD) per 1 mg at a wavelength of 450 nm in a range of about 0.5 to about 0.7.

The quantum dots may be dispersed (or disposed) in a matrix and may be provided as a quantum dot composite. An embodiment is a color conversion layer including the quantum dots described herein or a quantum dot composite including the same.

The quantum dots according to an embodiment include quantum dots including a metal including indium and zinc, and a non-metal including phosphorus and selenium, wherein the quantum dots (e.g., first quantum dots) have an optical density (OD) per 1 mg at a wavelength of 450 nm in a range of about 0.2 to about 0.27 and an emission peak of from about 500 nm to about 550 nm, or the quantum dots (e.g., second quantum dots) have an optical density (OD) per 1 mg at a wavelength of 450 nm in a range of in a range of about 0.5 to about 0.7 and an emission peak of from about 610 nm to about 660 nm. Moreover, the quantum dots do not include cadmium. In an embodiment, a display device may include (a color conversion layer including) the quantum dots such as the first quantum dots and/or the second quantum dots or a quantum dot composite including the quantum dots. The quantum dot composite may be included in a color conversion region of the color conversion layer.

In an embodiment, the display panel includes (a color conversion layer including) a quantum dot composite including a matrix, and a plurality of quantum dots, wherein the plurality of quantum dots includes a metal including indium and zinc, a non-metal including phosphorus and selenium, and optionally, sulfur, and

wherein the plurality of quantum dots includes first quantum dot(s) and second quantum dot(s),
wherein the first quantum dot(s) has (have) or exhibits (exhibit) an optical density (OD) per 1 mg at a wavelength of 450 nm in a range of about 0.2 to about 0.27 (e.g., greater than or equal to about 0.22 or 0.222 or 0.225 or higher and less than or equal to about 0.269), and an emission peak between about 500 nm to about 550 nm, and
wherein the second quantum dot(s) has (have) or exhibit(s) an optical density per 1 mg at a wavelength of about 450 nm in a range of about 0.5 to about 0.7 and an emission peak between about 610 nm to about 660 nm.

The optical density per unit weight of the quantum dots may be measured by using an optical density-measuring manner or instrument which is well known to a person of ordinary skill in the art, for example, based on a UV-Vis spectroscopy analysis. UV-Vis spectroscopy is based on (light) absorbance. For example, the quantum dots including a metal including indium and zinc and a non-metal including phosphorus and selenium, i.e., the quantum dots include indium, zinc, phosphorus, and selenium, and do not include cadmium, may be prepared or commercially purchased, and dispersed in toluene, as described herein. See, Examples. To determine whether the desired optical density is present, the quantum dot dispersion is added to a cuvette having an optical path of a specific length, for example, about 1 cm, and the optical density at the stated wavelength is measured in accordance with "[6] Measurement of Optical Density" as described herein.
Subsequently, after removing the solvent from the measured dispersion, a weight of the quantum dots in the measured dispersion is determined and used to convert the measured optical density to an optical density per 1 mg of the quantum dots, and thus obtain the optical density per unit weight of the quantum dots.
In an embodiment, the quantum dot(s) (e.g., the first quantum dot(s)) may be a quantum dot(s) emitting green light and having (e.g., exhibiting) an optical density per 1 mg at a wavelength of 460 nm in a range of about 0.12 to about 0.35 and an emission (luminescent) peak (in a wavelength range) of from about 500 nm (or about 530 nm)to about 550 nm (or about 540 nm).
In another embodiment, the quantum dot(s) (e.g., the second quantum dot(s)) may be a quantum dot(s) emitting red light and having (e.g., exhibiting) an optical density per 1 mg at a wavelength of 460 nm in a range of about 0.4 to about 0.5 and an emission (luminescent) peak (in a wavelength range) of from about 610 nm (or about 635 nm) to about 660 nm (or about 645 nm).
As the quantum dots(e.g., the first quantum dots, the second quantum dots, or the first quantum dots and the second quantum dots, hereinafter, simply referred to as "quantum dot") according to an embodiment may be dispersed in greater numbers, that is, at higher concentrations in various types of a matrices well known in the art of making a quantum dot color filter, a quantum dot composite prepared from such quantum dots may absorb more excitation light from a light emitting source that is configured to emit blue light. In other words, the quantum dot composite may exhibit an increased blue light absorption rate because an increase in the concentration of quantum dots in the matrix is made possible. Accordingly, this quantum dot composite may be advantageously applied to a color conversion layer and the like in various display devices.
As noted above, in a quantum dot composed of a core and a shell, the shell may passivate surface defects of the semiconductor nanocrystal core and structurally stabilize the quantum dots, improving luminous efficiency. However, it is to be expected that by reducing shell thickness in order to increase blue light absorption rate, the passivating effect of the shell may be adversely affected, and therefore, although the blue light absorption rate may increase, luminous efficiency is very likely or would be expected to decrease.
The quantum dots according to an embodiment, however, do not exhibit the above give and take or balance between shell thickness and luminous efficiency, that is, when the blue light absorption rate increases or ever so slightly decreases, the quantum dots exhibit an improvement in light conversion efficiency of a quantum dot composite including the quantum dots, such as, for example, as a quantum dot color filter.
When the emission peak of the quantum dots according to an embodiment is from about 500 nm to about 550 nm, that is, when the quantum dots emit green light or in case of the first quantum dot, an emission peak of the quantum dots may be greater than or equal to about 510 nm, greater than or equal to about 520 nm, greater than or equal to about 530 nm, or greater than or equal to about 535 nm, and less than or equal to about 545 nm, less than or equal to about 540 nm, or less than or equal to about 535 nm.
When the emission peak of the quantum dots according to an embodiment is from about 600 nm to about 660 nm, that is, when the quantum dots emit red light or in case of the second quantum dot, an emission peak of the quantum dots may be greater than or equal to about 615 nm, greater than or equal to about 620 nm, or greater than or equal to about 625 nm, and less than or equal to about 655 nm, less than or equal to about 650 nm, less than or equal to about 645 nm, less than or equal to about 640 nm, or less than or equal to about 630 nm.
As described above, a quantum dot (e.g., the first quantum dot and/or the second quantum dot) according to an embodiment may include a semiconductor nanocrystal core including indium and phosphorus, and a semiconductor nanocrystal shell disposed on the semiconductor nanocrystal core and including zinc and selenium, and the semiconductor nanocrystal shell may further include sulfur.

When the semiconductor nanocrystal shell does include sulfur, the semiconductor nanocrystal shell may further include a first semiconductor nanocrystal shell disposed on the semiconductor nanocrystal core, the first nanocrystal shell including zinc and selenium, and a second semiconductor nanocrystal shell disposed on the first semiconductor nanocrystal shell, the second nanocrystal shell including zinc and sulfur. If a first and second semiconductor nanocrystal shells are present, then the first semiconductor nanocrystal shell may not include ZnSeS. The first semiconductor nanocrystal shell may be disposed directly on the semiconductor nanocrystal core.

The second semiconductor nanocrystal shell may include ZnS. If a first and second semiconductor nanocrystal shells are present, then the second semiconductor nanocrystal shell may not include selenium. The second semiconductor nanocrystal shell may be disposed directly on the first semiconductor nanocrystal shell. The second semiconductor nanocrystal shell may be an outermost layer of the quantum dot.

In an embodiment, the semiconductor nanocrystal core may or may not further include zinc.

In an embodiment, the semiconductor nanocrystal core may be InP or InZnP. An (average) size of the core may be greater than or equal to about 1 nm, greater than or equal to about 1.5 nm, greater than or equal to about 2 nm, greater than or equal to about 3 nm, or greater than or equal to about 3.3 nm. An (average) size of the core may be less than or equal to about 5 nm, less than or equal to about 4 nm, or less than or equal to about 3.8 nm.

In an embodiment, a shell thickness of the quantum dot may be greater than or equal to about 1.5 nm, greater than or equal to about 1.6 nm, greater than or equal to about 1.7 nm, greater than or equal to about 1.8 nm, greater than or equal to about 1.9 nm, or greater than or equal to about 2 nm. In an embodiment, a thickness of the semiconductor nanocrystal shell may be less than or equal to about 2.5 nm, less than or equal to about 2.4 nm, less than or equal to about 2.3 nm, less than or equal to about 2.2 nm, or less than or equal to about 2.1 nm.

In an embodiment, a thickness of the first semiconductor nanocrystal shell may be about 3 monolayers (ML) or more, for example, about 3.5 ML or more, about 3.6 ML or more, about 3.7 ML or more, about 3.8 ML or more, about 3.9 ML or more, about 4 ML or more, about 4.1 ML or more, about 4.2 ML or more, about 4.3 ML or more, or about 4.4 ML or more. The thickness of the first semiconductor nanocrystal shell may be about 7 ML or less, for example, about 6 ML or less, or about 5 ML or less. In an embodiment, the thickness of the first semiconductor nanocrystal shell may be greater than or equal to about 0.9 nm, greater than or equal to about 1 nm, greater than or equal to about 1.1 nm, greater than or equal to about 1.2 nm, greater than or equal to about 1.3 nm, greater than or equal to about 1.4 nm, greater than or equal to about 1.43 nm, or greater than or equal to about 1.45 nm. In an embodiment, the thickness of the first semiconductor nanocrystal shell may be less than or equal to about 1.8 nm, less than or equal to about 1.75 nm, less than or equal to about 1.7 nm, less than or equal to about 1.6 nm, less than or equal to about 1.55 nm, or less than or equal to about 1.51 nm.

A (average) thickness of the second semiconductor nanocrystal shell may be less than or equal to about 0.65 nm, less than or equal to about 0.64 nm, less than or equal to about 0.63 nm, less than or equal to about 0.62 nm, less than or equal to about 0.61 nm, less than or equal to about 0.6 nm, or less than or equal to about 0.59 nm. The thickness of the second semiconductor nanocrystal shell may be greater than or equal to about 0.4 nm, greater than or equal to about 0.45 nm, greater than or equal to about 0.5 nm, greater than or equal to about 0.51 nm, greater than or equal to about 0.52 nm, greater than or equal to about 0.53 nm, or greater than or equal to about 0.54 nm.

The quantum dot may refer to one particle (single entity) or a plurality of particles, and may not contain harmful heavy metals (e.g., cadmium, lead, mercury, or a combination thereof). In other words, the quantum dot(s) do not include cadmium as defined herein.

In the (first and/or second) quantum dot of an embodiment, a weight ratio of zinc to indium, i.e., Zn/In, may be greater than or equal to about 10 and less than or equal to about 30, for example, greater than or equal to about 11 and less than or equal to about 29, greater than or equal to about 11.5 and less than or equal to about 27, greater than or equal to about 11.7 and less than or equal to about 26, but is not limited thereto. For example, the weight ratio of zinc to indium (Zn/In) may be greater than or equal to about 11.3, greater than or equal to about 11.5, greater than or equal to about 11.7, greater than or equal to about 11.75, greater than or equal to about 12, greater than or equal to about 13, greater than or equal to about 13.5, greater than or equal to about 14, greater than or equal to about 15, greater than or equal to about 16, greater than or equal to about 17, greater than or equal to about 18, greater than or equal to about 19, greater than or equal to about 20, greater than or equal to about 21, greater than or equal to about 22, greater than or equal to about 23, greater than or equal to about 24, or greater than or equal to about 25, and less than or equal to about 30, less than or equal to about 29, less than or equal to about 28, less than or equal to about 27.5, less than or equal to about 27, less than or equal to about 26.5, less than or equal to about 26, less than or equal to about 25.8, less than or equal to about 25.7, less than or equal to about 25.5, less than or equal to about 25, less than or equal to about 24, less than or equal to about 23, less than or equal to about 22, less than or equal to about 21, less than or equal to about 20, less than or equal to about 19, less than or equal to about 18, less than or equal to about 17, less than or equal to about 16, less than or equal to about 15.5, less than or equal to about 15, less than or equal to about 14, less than or equal to about 13.5, less than or equal to about 13, less than or equal to about 12.5, less than or equal to about 12, less than or equal to about 11.75, less than or equal to about 11.5, less than or equal to about 11, or less than or

equal to about 10.5, but is not limited thereto.

In the (first and/or second) quantum dot according to an embodiment, a weight ratio of selenium to indium (Se/In) may be greater than or equal to about 2.9 and less than or equal to about 20, for example, greater than or equal to about 3, greater than or equal to about 4, greater than or equal to about 5, greater than or equal to about 6, greater than or equal to about 7, greater than or equal to about 8, greater than or equal to about 9, greater than or equal to about 10, greater than or equal to about 11, greater than or equal to about 12, greater than or equal to about 13, greater than or equal to about 14, greater than or equal to about 15, greater than or equal to about 16, greater than or equal to about 17, greater than or equal to about 18, or greater than or equal to about 19, and less than or equal to about 20, less than or equal to about 19, less than or equal to about 18, less than or equal to about 17, less than or equal to about 16, less than or equal to about 15, less than or equal to about 14, less than or equal to about 13, less than or equal to about 12, less than or equal to about 11, less than or equal to about 10.5, less than or equal to about 10, less than or equal to about 9, less than or equal to about 8, less than or equal to about 7, less than or equal to about 6, less than or equal to about 5, less than or equal to about 4, or less than or equal to about 3, but is not limited thereto.

In the (first and/or second) quantum dot according to an embodiment, a weight ratio of sulfur to indium (S/In) may be greater than or equal to about 1 and less than or equal to about 10, for example, greater than or equal to about 1.2 and less than or equal to about 9, greater than or equal to about 1.25 and less than or equal to about 8.7, but is not limited thereto. For example, the weight ratio of S/In may be greater than or equal to about 1.2, greater than or equal to about 1.28, greater than or equal to about 1.3, greater than or equal to about 1.5, greater than or equal to about 2, greater than or equal to about 3, greater than or equal to about 4, greater than or equal to about 5, greater than or equal to about 6, greater than or equal to about 7, greater than or equal to about 8, or greater than or equal to about 9, and less than or equal to about 10, less than or equal to about 9.5, less than or equal to about 9, less than or equal to about 8.7, less than or equal to about 8.5, less than or equal to about 8, less than or equal to about 7, or less than or equal to about 6, but is not limited thereto. In considering the weight ratio of sulfur to indium in the quantum dot, a content of sulfur derived from (or is present in) a ligand capable of binding to the surface of the quantum dot as described below is not to be included in the determination of the weight ratio of S/In.

In the (first and/or second) quantum dot, a mole ratio of indium to a sum of moles of sulfur and selenium In/(S+Se) may be greater than or equal to about 0.09, greater than or equal to about 0.095, greater than or equal to about 0.097, or greater than or equal to about 0.0975. In the quantum dot, a mole ratio of indium to the sum of moles of sulfur and selenium In/(S+Se) may be less than or equal to about 0.12, less than or equal to about 0.115, less than or equal to about 0.113, less than or equal to about 0.111, less than or equal to about 0.11, or less than or equal to about 0.109. In considering the mole ratio of sulfur to indium in the quantum dot, moles of sulfur derived from (or is present in) a ligand capable of binding to the surface of the quantum dot as described below is not to be included in the determination of the mole ratio of In/(S+Se).

In the (first and/or second) quantum dot, the mole ratio of the sum of moles of sulfur and selenium to moles of indium (S+Se)/In, may be greater than or equal to about 8.96, greater than or equal to about 9.1, greater than or equal to about 9.2, greater than or equal to about 9.3, greater than or equal to about 9.4, greater than or equal to about 9.5, greater than or equal to about 9.6, greater than or equal to about 9.65, greater than or equal to about 9.7, greater than or equal to about 9.8, greater than or equal to about 9.9, greater than or equal to about 10, greater than or equal to about 10.1, or greater than or equal to about 10.2. In the quantum dot, the mole ratio of the sum of moles of sulfur and selenium to moles of indium, i.e., (S+Se)/In, may be less than or equal to about 10.5, less than or equal to about 10.3, or less than or equal to about 10.25. In considering the mole ratio of the sum of moles of sulfur and selenium to the moles of indium, the moles of sulfur derived from (or is present in) a ligand capable of binding to the surface of the quantum dot as described below is not to be included in the determination of the mole ratio of (S+Se)/In.

A size of the (first and/or second) quantum dot according to an embodiment may be greater than or equal to about 5 nm, greater than or equal to about 5.5 nm, greater than or equal to about 6 nm, greater than or equal to about 6.5 nm, greater than or equal to about 7.5 nm, greater than or equal to about 7.6 nm, or greater than or equal to about 7.7 nm. The size of the (first and/or second) quantum dot may be less than or equal to about 8 nm, less than or equal to about 7.9 nm, less than or equal to about 7.8 nm, less than or equal to about 7.5 nm, less than or equal to about 7 nm, less than or equal to about 6.5 nm, less than or equal to about 6 nm, or less than or equal to about 5.5 nm.

The size or average size of the (first and/or second) quantum dots may be calculated from an electron microscope analysis image. In an embodiment, the size (or average size) may be a diameter or equivalent diameter (or an average value thereof) determined from electron microscopy image analysis.

The shape of the (first and/or second) quantum dot is not particularly limited, and may include, for example, spherical, polyhedral, pyramidal, multi-pod, cubic, nanotubes, nanowires, nanofibers, nanosheets, or a combination thereof, but is not limited thereto.

The (first and/or second) quantum dot may include an organic ligand and/or an organic solvent to be described later on the surface of the quantum dot. The organic ligand and/or the organic solvent may be bound to a surface of the quantum dot.

In an embodiment, the (first and/or second) quantum dot may have a quantum efficiency of greater than or equal to about 90%, greater than or equal to about 91%, greater than or equal to about 92%, greater than or equal to about 93%, greater than or equal to about 94%, or greater than or equal to about 95% in a solution state or a solid state. In addition, the (first and/or second) quantum dot may have a full width at half maximum (FWHM) of less than or equal to about 40 nm, for example, less than or equal to about 39 nm, less than or equal to about 37 nm, less than or equal to about 36 nm, or less than or equal to about 35 nm, in a solution state or a solid state. The quantum dot may have a FWHM of greater than or equal to about 5 nm, for example, greater than or equal to about 10 nm, for example, greater than or equal to about 15 nm, or, for example, greater than or equal to 20 nm.

The (first and/or second) quantum dot according to an embodiment may be prepared by a method that includes preparing a core that includes semiconductor nanocrystals including indium and phosphorus, and reacting the precursors forming the semiconductor nanocrystal shell with the core to form a semiconductor nanocrystal shell including zinc, selenium, and optionally sulfur, on the core in a suitable solvent. Furthermore, the quantum dot according to an embodiment may be prepared by a method that further includes introducing and further reacting precursors for forming an additional semiconductor nanocrystal shell including zinc and sulfur, and optionally selenium, on the particle in which the semiconductor nanocrystal shell is formed on the semiconductor nanocrystal core.

When the semiconductor nanocrystal shell, or optionally, the additional semiconductor nanocrystal shell is formed, appropriate organic ligands and/or surfactants may be included. In addition, the preparing of the semiconductor nanocrystal core may include preparing precursors of indium and phosphorus compounds for preparing the semiconductor nanocrystal core and reacting them to prepare an in-situ semiconductor nanocrystal core or using a commercially available semiconductor nanocrystal core. The method of preparing quantum dots according to an embodiment as described above may be performed through various quantum dot preparation methods well known to those of ordinary skill in the art.

In each reaction step for producing the quantum dot, the relative content between the zinc precursor, the selenium precursor, and the sulfur precursor relative to indium, and a respective total amount of each precursor may be adjusted to satisfy the composition of the quantum dot as mentioned above. In each step, the desired reaction time may be adjusted to obtain the desired composition and/or structure (e.g., core/multilayer shell structure) of the final quantum dot in accordance with general knowledge in the art.

The zinc precursor is not particularly limited, and may be a Zn metal powder, an alkylated Zn compound, a Zn alkoxide, a C2 to C10 Zn carboxylate, a Zn nitrate, a Zn perchlorate, a Zn sulfate, a Zn acetylacetonate, a Zn halide, a Zn cyanide, a Zn hydroxide, a Zn oxide, a Zn peroxide, or a combination thereof. Examples of the first shell precursor may include dimethyl zinc, diethyl zinc, zinc acetate, zinc acetylacetonate, zinc iodide, zinc bromide, zinc chloride, zinc fluoride, zinc carbonate, zinc cyanide, zinc nitrate, zinc oxide, zinc peroxide, zinc perchlorate, and/or zinc sulfate, etc.

The selenium-containing precursor is not particularly limited, and may be for example, selenium, selenium-trioctylphosphine (Se-TOP), selenium-tributylphosphine (Se-TBP), selenium-triphenylphosphine (Se-TPP), or a combination thereof, but is not limited thereto.

The sulfur-containing precursor is not particularly limited, and may be, for example, a sulfur powder, hexane thiol, octane thiol, decane thiol, dodecane thiol, hexadecane thiol, mercaptopropyl silane, sulfur-trioctylphosphine (S-TOP), sulfur-tributylphosphine (S-TBP), sulfur-triphenylphosphine (S-TPP), sulfur-trioctylamine (S-TOA), trimethylsilyl sulfur, ammonium sulfide, sodium sulfide, or a combination thereof.

The organic ligand may include RCOOH, $RNH_2$, $R_2NH$, $R_3N$, RSH, $RH_2PO$, $R_2HPO$, RsPO, $RH_2P$, $R_2HP$, RsP, ROH, RCOOR', $RPO(OH)_2$, $R_2POOH$ (wherein, R and R' are each independently (e.g., C1 to C40 or C3 to C35 or C8 to C24) substituted or unsubstituted aliphatic hydrocarbon group (e.g., alkyl group, alkenyl group, alkynyl group), or (e.g., C6 to C40 or C6 to C24) substituted or unsubstituted aromatic hydrocarbon group (e.g., aryl group)), or a combination thereof.

The organic ligand coordinates to the surface of the prepared nanocrystal which facilitates the dispersion of the nanocrystals to in the solution phase. Specific examples of the organic ligand may include methane thiol, ethane thiol, propane thiol, butane thiol, pentane thiol, hexane thiol, octane thiol, dodecane thiol, hexadecane thiol, octadecane thiol, benzyl thiol; methane amine, ethane amine, propane amine, butyl amine, pentyl amine, hexyl amine, octyl amine, dodecyl amine, hexadecyl amine, octadecyl amine, dimethyl amine, diethyl amine, dipropyl amine; methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, benzoic acid; phosphine such as substituted or unsubstituted methyl phosphine (e.g., trimethyl phosphine, methyldiphenyl phosphine, etc.), substituted or unsubstituted ethyl phosphine (e.g., triethyl phosphine, ethyldiphenyl phosphine, etc.), substituted or unsubstituted propyl phosphine, substituted or unsubstituted butyl phosphine, substituted or unsubstituted pentyl phosphine, substituted or unsubstituted octylphosphine (e.g., trioctylphosphine (TOP)), and the like; phosphine oxide such as substituted or unsubstituted methyl phosphine oxide (e.g., trimethyl phosphine oxide, methyldiphenyl phosphine oxide, etc.), substituted or unsubstituted ethyl phosphine oxide (e.g., triethyl phosphine oxide, ethyldiphenyl phosphine oxide, etc.), substituted or unsubstituted propyl phosphine oxide, substituted or unsubstituted butyl phosphine oxide, substituted or unsubstituted octylphosphine oxide

(e.g., trioctylphosphine oxide (TOPO)), and the like; diphenyl phosphine, a triphenyl phosphine, or an oxide thereof; phosphonic acid, and the like, but are not limited thereto. The organic ligand may be used alone or as a mixture of two or more ligands.

The (organic) solvent may include C6 to C22 primary amines such as hexadecylamine; C6 to C22 secondary amines such as dioctylamine; C6 to C40 tertiary amines such as trioctylamine; nitrogen-containing heterocyclic compounds such as pyridine; C6 to C40 aliphatic hydrocarbons (e.g., alkanes, alkenes, alkynes, etc.) such as hexadecane, octadecane, octadecene, and squalane; C6 to C30 aromatic hydrocarbons such as phenyldodecane, phenyltetradecane, and phenyl hexadecane; phosphine substituted with a C6 to C22 alkyl group such as trioctylphosphine; phosphine oxide substituted with a C6 to C22 alkyl group such as trioctylphosphine oxide; C12 to C22 aromatic ethers such as phenyl ether, benzyl ether, and a combination thereof. Types and contents of the solvent may be appropriately selected in consideration of the types of the precursors and the organic ligand.

The semiconductor nanocrystal particles include indium and phosphorus in the core as described above. The semiconductor nanocrystal particle (hereinafter, referred to as "core") are commercially available or may be synthesized by a known method for producing an indium phosphide-based core. The core of an embodiment may be prepared by a hot injection method in which a solution including metal precursors, such as, for example, an indium precursor, and the like, and, optionally, a ligand, is heated to a high temperature (for example, about 200 °C or higher), and a phosphorus precursor is injected.

When a nonsolvent is added to the prepared final reaction solution, the precipitation of the nanocrystals coordinated with the organic ligand is facilitated, and then may be separated (e.g., with use of a centrifuge). The nonsolvent may be a polar solvent that is miscible with the solvent used in the reaction but cannot readily disperse the nanocrystals. The nonsolvent may be selected depending on the solvent used in the reaction and may be for example, acetone, ethanol, butanol, isopropanol, ethanediol, water, tetrahydrofuran (THF), dimethylsulfoxide (DMSO), diethylether, formaldehyde, acetaldehyde, a solvent having a similar solubility parameter to the foregoing solvents, or a combination thereof. The separation may be performed by centrifugation, precipitation, chromatography, or distillation. Separated nanocrystals may be washed with a washing solvent as needed. The washing solvent has no particular limit and may have a similar solubility parameter to that of the ligand and may, for example, include hexane, heptane, octane, chloroform, toluene, benzene, and the like.

A display panel according to another embodiment includes (a color conversion layer including) a quantum dot composite(s) including a matrix, and a plurality of quantum dots described herein and particles of titanium dioxide ($TiO_2$) that are dispersed in the matrix. The plurality of quantum dots in the quantum dot composite include a metal including indium and zinc, and a non-metal including phosphorus and selenium, and optionally, sulfur, and in the display panel (or in the color conversion layer or in the color conversion regions and the light transmitting region), a weight ratio of indium to titanium (In/Ti) may be greater than or equal to about 0.1 and less than or equal to about 0.7 (or less than or equal to about 0.56, less than or equal to about 0.51, less than or equal to about 0.5, less than or equal to about 0.36, less than or equal to about 0.34, less than or equal to about 0.32, less than or equal to about 0.22), a weight ratio of phosphorus to titanium (P/Ti) may be greater than or equal to about 0.05 and less than or equal to about 0.2 (or less than or equal to about 0.16, less than or equal to about 0.15, or less than or equal to about 0.14).

In an embodiment, in the display panel or (or in the color conversion layer or in the color conversion regions and the light transmitting region), a weight ratio of a weight of selenium to titanium (Se/Ti) may be greater than or equal to about 0.5 and less than or equal to about 5, or greater than or equal to about 0.5 and less than or equal to about 3.

In reference to a quantum dot composite, or a display panel that includes a quantum dot composite, in accordance with an embodiment, at times Applicant refers to a content ratio (i.e., a weight ratio or a mole ratio) of a stated element (EL), e.g., indium, phosphorous, or selenium, to titanium (Ti), e.g., in the paragraph above or in the claims that follow, the stated weight or mole ratio (EL/Ti) is determined by the weight or mole content of the element in the quantum dots (i.e., core and shell(s)) and the weight or mole content of titanium, respectively, in the titanium dioxide that is present in the quantum dot composite or in across the display panel.

As described above, the quantum dot(s) according to an embodiment, when prepared into a quantum dot composite for forming a quantum dot color filter and the like, may be included in a relatively large number (i.e., at higher concentrations by weight) in a pixel constituting the quantum dot color filter due to a reduction in shell thickness of the quantum dot(s). The shell thickness is appropriately reduced to increase a blue light absorption rate with little or no reduction in luminous efficiency, as a result form the reduced weight of a respective quantum dot. The quantum dot composite includes the quantum dots having a relatively thin shell within a predetermined level, and thereby may include the stated elements within the specific content (weight or mole) ranges described herein. Accordingly, a display panel including the quantum dot composite may also have each element within a specific content range in a color conversion region, which includes the quantum dot composite. Furthermore, the display panel according to an embodiment includes the quantum dot composite including a plurality of the quantum dots according to an embodiment with a plurality of titanium dioxide in a matrix. In the display panel according to an embodiment, a ratio of a content of a stated element (e.g., a ratio based on weight or the number of moles) included in the quantum dot, for example, a content (e.g., weight

or the number of moles) of indium, phosphorus, and selenium relative to a content (e.g., a weight or the number of moles) of titanium derived from the titanium dioxide included in the quantum dot composite may be present within the specific ranges stated. The content ratios of these elements may be different from a weight ratio or a mole ratio of the corresponding elements in a more conventional quantum dot (or quantum dot composite) or a display panel including conventional quantum dot constituting the stated elements and titanium dioxide.

In an embodiment, a weight ratio of a weight of indium to a weight of titanium (In/Ti), i.e., from the titanium dioxide, in a display panel (or in the color conversion layer or in the color conversion regions and the light transmitting region) that includes the quantum dot composite (or in the color conversion regions and the light transmitting region) may be greater than or equal to about 0.15 and less than or equal to about 0.7, less than or equal to about 0.5, less than or equal to about 0.4, for example, greater than or equal to about 0.16 and less than or equal to about 0.36, and for example. When the content of titanium dioxide in the display panel or in the color conversion layer is about 5 wt% to about 10 wt%, as the content of the titanium dioxide increases and the content of indium remains constant, the weight ratio of In/Ti will be at a lower end within the above weight percent range, and as the content of titanium dioxide decreases within the above range, the weight ratio of In/Ti will be at a higher end within the above range. For example, when titanium dioxide is present in about 10 wt%, the weight ratio of In/Ti may be about 0.16 to about 0.26 and when the content of titanium dioxide is about 5 wt%, the weight ratio of In/Ti may be about 0.22 to about 0.36.

In addition, a weight ratio of a weight of phosphorus to a weight of titanium (P/Ti) in the display panel (for example, in the color conversion layer or in the color conversion regions and the light transmitting region) may be greater than or equal to about 0.06 and less than or equal to about 0.2, less than or equal to about 0.15, or less than or equal to about 0.13, for example, greater than or equal to about 0.06 and less than or equal to about 0.12. When the content of titanium dioxide in a display panel (or in the color conversion layer or in the color conversion regions and the light transmitting region) is about 5 wt% to about 10 wt%, as the content of the titanium dioxide increases as the content of phosphorous remains constant, the weight ratio of P/Ti will be at a lower end within the above range, and as the content of titanium dioxide decreases within the above range the weight ratio of P/Ti will be at a higher value within the above range. For example, when titanium dioxide is present in about 10 wt%, the weight ratio of P/Ti may be about 0.06 to about 0.08, and when the content of the titanium dioxide is about 5 wt%, the weight ratio of P/Ti may be about 0.08 to about 0.12, in the display device.

Furthermore, a weight ratio of a weight of selenium to a weight of titanium (Se/Ti) in a display panel (for example, in the color conversion layer or in the color conversion regions and the light transmitting region) may be greater than or equal to about 0.8 and less than or equal to about 2.7, for example, greater than or equal to about 0.9 and less than or equal to about 2.66. When a content of titanium dioxide in a display panel is about 5 wt% to about 10 wt%, as the content of the titanium dioxide increases and the content of the selenium remains constant, the weight ratio of Se/Ti will be at a lower value within the above range, and as the content of titanium dioxide decreases within the above range, the weight ratio of Se/Ti will be at a higher value within the above range. For example, when titanium dioxide is present in about 10 wt% in a display device (or in the color conversion layer or in the color conversion regions and the light transmitting region), the weight ratio of Se/Ti may be about 0.95 to about 1.95, and when the content of the titanium dioxide is about 5 wt% in the display device, the weight ratio of Se/Ti may be about 1.3 to about 2.66.

A content of each element to a content of Ti, i.e., from the titanium oxide, in a display panel, may be converted to a ratio of number of moles of each element. In an embodiment, a mole ratio of moles of indium to moles of titanium (In/Ti) in a display panel (or in the color conversion layer or in the color conversion regions and the light transmitting region) may be greater than or equal to about 0.05 and less than or equal to about 0.2, a mole ratio of moles of phosphorus to moles of titanium (P/Ti) may be greater than or equal to about 0.05 and less than or equal to about 0.2, and a mole ratio of moles of selenium to moles of the titanium (Se/Ti) may be greater than or equal to about 1 and less than or equal to about 4, in the display device (e.g., in the color conversion layer or in the color conversion regions and the light transmitting region).

In the embodiments, in an application of the quantum dot composite including the quantum dots according to an embodiment and titanium dioxide to a display panel, a content (e.g., mole or weight) ratio among elements recited herein, that is, a ratio of weights or moles of indium, phosphorus, and selenium to weights or moles of titanium (Ti) derived from titanium dioxide included in the display panel (e.g., in the color conversion layer or in the color conversion regions and the light transmitting region), may be obtained by taking into consideration (e.g., comparing) each of weights or moles of indium, phosphorus, and selenium to that of titanium (in the display panel or in the color conversion layer or in the color conversion regions and the light transmitting region).

Meanwhile, the quantum dot composite may be produced from a composition including the quantum dot(s) according to an embodiment (e.g., in a solid state through polymerization, etc.).

The quantum dot composition may include (e.g., a plurality of) the aforementioned quantum dot(s); optionally a monomer, a dispersant, or a combination thereof; and (organic) solvents and/or liquid vehicles. The dispersant may disperse the quantum dots. The dispersant may include a carboxylic acid group-containing compound (monomer or polymer). The composition may further include a (photo)polymerizable monomer including a carbon-carbon double bond,

and optionally a (thermal or photo) initiator. The composition may be a photosensitive composition.

Since the details for the quantum dots in the composition are the same as those of the quantum dots according to the embodiment described above, detailed descriptions thereof will be omitted.

The content of the quantum dots in the composition may be appropriately adjusted in consideration of the end use (e.g., such as a color conversion layer of an emission type color filter or a color conversion panel). In the composition (or composite), the content of quantum dot(s) may be greater than or equal to about 1 wt%, for example, greater than or equal to about 2 wt%, greater than or equal to about 3 wt%, greater than or equal to about 4 wt%, greater than or equal to about 5 wt%, greater than or equal to about 6 wt%, greater than or equal to about 7 wt%, greater than or equal to about 8 wt%, greater than or equal to about 9 wt%, greater than or equal to about 10 wt%, greater than or equal to about 15 wt%, greater than or equal to about 20 wt%, greater than or equal to about 25 wt%, greater than or equal to about 30 wt%, greater than or equal to about 35 wt%, or greater than or equal to about 40 wt% based on the total weight or total solid content of the composition or composite. The content of the quantum dot may be less than or equal to about 70 wt%, less than or equal to about 65 wt%, less than or equal to about 60 wt%, less than or equal to about 55 wt%, less than or equal to about 50 wt%, less than or equal to about 45 wt%, less than or equal to about 40 wt%, or less than or equal to about 30 wt% based on the total weight or total solid content of the composition or composite.

Herein, (e.g., when the quantum dot composition includes an organic solvent), the content based on the total solids in the composition may correspond to the content of the corresponding component in the quantum dot composite. For example, when the quantum dot composition is a solvent-free system (not including an organic solvent), the content range in the composition may correspond to the content range in the composite.

In the composition according to an embodiment, the dispersant may contribute to achieving the necessary dispersibility of quantum dots and/or titanium dioxide. In an embodiment, the dispersant may include an organic compound (e.g., a monomer or a polymer) (e.g., containing a carboxylic acid group), for example a binder polymer. The dispersant or binder polymer may be an insulating polymer.

The organic compound having the carboxylic acid group may include

a combination of monomers including a first monomer having a carboxylic acid group and a carbon-carbon double bond, a second monomer having a carbon-carbon double bond and a hydrophobic moiety and not having a carboxylic acid group, and optionally a third monomer having a carbon-carbon double bond and a hydrophilic moiety and not having a carboxylic acid group, or a copolymer thereof;

a multiple aromatic ring-containing polymer (hereinafter, cardo binder) having a backbone in which two aromatic rings in a main chain are bonded to quaternary carbon atoms that are constituent atoms of other cyclic moieties, and having a carboxylic acid group (-COOH); or

a combination thereof.

The dispersant may include the aforementioned first monomer, second monomer, and optionally, the third monomer.

The content of the dispersant (or binder polymer) in the composition may be greater than or equal to about 0.5 wt%, for example, greater than or equal to about 1 wt%, greater than or equal to about 5 wt%, greater than or equal to about 10 wt%, greater than or equal to about 15 wt%, greater than or equal to about 20 wt%, greater than or equal to about 30 wt%, greater than or equal to about 40 wt%, or greater than or equal to about 50 wt% based on the total weight or total solid content of the composition or composite, but is not limited thereto. The content of the dispersant (or binder polymer) may be less than or equal to about 60 wt%, less than or equal to about 50 wt%, less than or equal to about 40wt%, less than or equal to about 35 wt%, less than or equal to about 33 wt%, less than or equal to about 30 wt%, less than or equal to about 20 wt%, or less than or equal to about 10 wt% based on the total weight or total solid content of the composition or composite. The content of the dispersant (or binder polymer) may be about 0.5 wt% to about 55 wt% based on the total weight or total solid content of the composition or composite.

The composition may include a polymerizable (e.g., photopolymerizable) monomer including the carbon-carbon double bond. The monomer may include a (e.g., photopolymerizable) (meth)acrylic monomer. The monomer may be a precursor for the insulating polymer.

The content of the monomer may be greater than or equal to about 0.5 wt%, for example, greater than or equal to about 1 wt%, greater than or equal to about 2 wt%, greater than or equal to about 5 wt%, greater than or equal to about 10 wt%, greater than or equal to about 15 wt%, greater than or equal to about 20 wt%, greater than or equal to about 25 wt%, or greater than or equal to about 30 wt% based on the total weight or total solid content of the composition or composite. The content of the (photo)polymerizable monomer may be less than or equal to about 60 wt%, less than or equal to about 50 wt%, less than or equal to about 40 wt%, less than or equal to about 30 wt%, less than or equal to about 28 wt%, less than or equal to about 25 wt%, less than or equal to about 23 wt%, less than or equal to about 20 wt%, less than or equal to about 18 wt%, less than or equal to about 17 wt%, less than or equal to about 16 wt%, or less than or equal to about 15 wt% based on the total weight or total solid content of the composition or composite.

The (photo)initiator included in the composition may be used for (photo)polymerization of the aforementioned monomer. The initiator is a compound accelerating a radical reaction (e.g., radical polymerization of monomer) by producing radical chemical species under a mild condition (e.g., by heat or light). The initiator may be a thermal initiator or a photoinitiator. The initiator is not particularly limited and may be appropriately selected.

In the composition, the content of the initiator may be appropriately adjusted considering types and contents of the polymerizable monomers. In an embodiment, the content of the initiator may be greater than or equal to about 0.01 wt%, for example, greater than or equal to about 1 wt%, greater than or equal to about 5 wt%, or greater than or equal to about 10 wt%, and for example, less than or equal to about 9 wt%, less than or equal to about 8 wt%, less than or equal to about 7 wt%, less than or equal to about 6 wt%, or less than or equal to about 5 wt% based on the total weight of the composition (or the total weight of the solid content), but is not limited thereto.

The composition may further include a (multi- or monofunctional) thiol compound having at least one thiol group at the terminal end, or a combination thereof.

In an embodiment, the content of the titanium dioxide ($TiO_2$) particles in the composite may be greater than or equal to about 1 wt%, greater than or equal to about 5 wt%, greater than or equal to about 10 wt%, greater than or equal to about 15 wt%, greater than or equal to about 20 wt%, greater than or equal to about 25 wt%, greater than or equal to about 30 wt%, or greater than or equal to about 35 wt%, and/or less than or equal to about 60 wt%, less than or equal to about 50 wt%, less than or equal to about 40 wt%, less than or equal to about 30 wt%, less than or equal to about 25 wt%, less than or equal to about 20 wt%, less than or equal to about 15 wt%, less than or equal to about 10 wt%, or less than or equal to about 5 wt%, for example, about 5 wt% to about 10 wt% based on the total weight (or the solid weight) of the composite.

The titanium dioxide ($TiO_2$) exists in the form of particulates in the matrix, and the diameter of the particulates is not particularly limited and may be appropriately selected. A diameter (or average diameter) of the titanium dioxide ($TiO_2$) particle(s) may be greater than or equal to about 100 nm, for example greater than or equal to about 150 nm, or greater than or equal to about 200 nm, and less than or equal to about 1000 nm, less than or equal to about 800 nm, less than or equal to about 500 nm, less than or equal to about 400 nm, or less than or equal to about 300 nm.

The (multi) thiol compound may be a dithiol compound, a trithiol compound, a tetrathiol compound, or a combination thereof. For example, the thiol compound may be glycoldi-3-mercaptopropionate, glycoldimercapto acetate, trimethylolpropanetris (3-mercaptopropionate), pentaerythritol tetrakis(3-mercaptopropionate), pentaerythritol tetrakis(2-mercaptoacetate), 1,6-hexanedithiol, 1,3-propanedithiol, 1,2-ethanedithiol, polyethylene glycol dithiol including 1 to 10 ethylene glycol repeating units, or a combination thereof.

A content of the (multi) thiol compound may be less than or equal to about 60 wt%, less than or equal to about 50 wt%, less than or equal to about 40 wt%, less than or equal to about 30 wt%, less than or equal to about 20 wt%, less than or equal to about 10 wt%, less than or equal to about 9 wt%, less than or equal to about 8 wt%, less than or equal to about 7 wt%, less than or equal to about 6 wt%, or less than or equal to about 5 wt% based on the total weight of the composition (or a total weight of solids). The content of the thiol compound may be greater than or equal to about 0.1 wt%, for example, greater than or equal to about 0.5 wt%, greater than or equal to about 1 wt%, greater than or equal to about 5 wt%, greater than or equal to about 10 wt%, greater than or equal to about 15 wt%, greater than or equal to about 20 wt%, or greater than or equal to about 25 wt% based on the total weight of the composition (or a total weight of solids).

The composition may further include an organic solvent (or liquid vehicle, hereinafter referred to as a solvent). The type of useable solvent is not particularly limited. Non-limiting examples of the solvent or liquid vehicle may be ethyl 3-ethoxy propionate; ethylene glycols such as ethylene glycol, diethylene glycol, polyethylene glycol, and the like; glycolethers such as ethylene glycolmonomethylether, ethylene glycolmonoethylether, diethylene glycolmonomethylether, ethylene glycoldiethylether, diethylene glycoldimethylether, and the like; glycoletheracetates such as ethylene glycolacetate, ethylene glycolmonoethyletheracetate, diethylene glycolmonoethyletheracetate, diethylene glycolmonobutyletheracetate, and the like; propylene glycols such as propylene glycol, and the like; propylene glycolethers such as propylene glycolmonomethylether, propylene glycolmonoethylether, propylene glycolmonopropylether, propylene glycolmonobutylether, propylene glycoldimethylether, dipropylene glycoldimethylether, propylene glycoldiethylether, dipropylene glycoldiethylether, and the like; propylene glycoletheracetates such as propylene glycolmonomethyl ether acetate, dipropylene glycolmonoethyletheracetate, and the like; amides such as N-methylpyrrolidone, dimethyl formamide, dimethyl acetamide, and the like; ketones such as methylethylketone(MEK), methylisobutylketone (MIBK), cyclohexanone, and the like; petroleums such as solvent naphtha, and the like; esters such as ethyl acetate, butyl acetate, ethyl lactate, and the like; ethers such as tetrahydrofuran, diethyl ether, dipropyl ether, dibutyl ether, and the like, chloroform, C1 to C40 aliphatic hydrocarbon (e.g., alkane, alkene, or alkyne), a halogen- (e.g., chlorine-)substituted C1 to C40 aliphatic hydrocarbon (e.g., dichloroethane, trichloromethane, and the like), C6 to C40 aromatic hydrocarbon (e.g., toluene, xylene, and the like), a halogen-(e.g., chlorine-) substituted C6 to C40 aromatic hydrocarbon; dimethylsulfoxide; or a combination thereof, but are not limited thereto.

The types and contents of the organic solvent may be appropriately determined by considering the aforementioned main components (i.e., the quantum dots, the dispersant, the polymerizable monomer, the initiator, and if used, the thiol compound,) and types and contents of additives which is described later. The composition may include a solvent in a residual amount except for a desired content of the (non-volatile) solid.

The composition (e.g., ink composition) may have a viscosity at 25 °C of greater than or equal to about 4 centipoise (cPs), greater than or equal to about 5 cPs, greater than or equal to about 5.5 cPs, greater than or equal to about 6.0 cPs, or greater than or equal to about 7.0 cPs. The composition may have a viscosity at 25 °C of less than or equal to about 12 cPs, less than or equal to about 10 cPs, or less than or equal to about 9 cPs.

When used for inkjet, the composition may be discharged to a substrate at room temperature, and may be heated, for example, to form a quantum dot-polymer composite film or a pattern thereof. The ink composition, while having the aforementioned viscosity, may have a surface tension at about 23 °C of greater than or equal to about 21 milliNewtons per meter (mN/m), greater than or equal to about 22 mN/m, greater than or equal to about 23 mN/m, greater than or equal to about 24 mN/m, greater than or equal to about 25 mN/m, greater than or equal to about 26 mN/m, greater than or equal to about 27 mN/m, greater than or equal to about 28 mN/m, greater than or equal to about 29 mN/m, greater than or equal to about 30 mN/m, or greater than or equal to about 31 mN/m and less than or equal to about 40 mN/m, less than or equal to about 39 mN/m, less than or equal to about 38 mN/m, less than or equal to about 36 mN/m, less than or equal to about 35 mN/m, less than or equal to about 34 mN/m, less than or equal to about 33 mN/m, or less than or equal to about 32 mN/m. The ink composition may have a surface tension of less than or equal to about 31 mN/m, less than or equal to about 30 mN/m, less than or equal to about 29 mN/m, or less than or equal to about 28 mN/m.

In an embodiment, the composition may further include, for example, an additive included in the composition for photoresist or the ink composition. The additive may include a light diffusing agent, a leveling agent, a coupling agent, and the like. For specific details, for example, reference may be made to the contents described in US-2017-0052444-A1.

The composition may be prepared by a method that includes preparing a quantum dot dispersion including the aforementioned quantum dots, dispersant, and solvent; and mixing an initiator; a polymerizable monomer (e.g., an acrylic monomer); and optionally a thiol compound; titanium dioxide ($TiO_2$); and optionally the aforementioned additives in the quantum dot dispersion. Each of the aforementioned components may be mixed sequentially or simultaneously, and the order is not particularly limited.

The composition may be used to provide a pattern of a quantum dot composite (e.g., a quantum dot-polymer composite). The composition may provide a quantum dot-polymer composite by (e.g., radical) polymerization. The composition for preparing a quantum dot composite according to an embodiment may be a quantum dot-containing photoresist composition applicable to a photolithography method. The composition according to an embodiment may be an ink composition capable of providing a pattern by a printing method (e.g., a droplet discharging method such as inkjet printing).

In an embodiment, the quantum dot composite includes, for example, a polymer matrix, and the aforementioned quantum dot(s) and titanium dioxide ($TiO_2$) dispersed in the matrix. In the composite, titanium dioxide ($TiO_2$) acts as a light diffusing agent, so that the light absorbed from the excitation light stays longer in the quantum dot composite and may be more absorbed by the quantum dots.

The (polymer) matrix may include a crosslinked polymer and/or a linear polymer. The crosslinked polymer may include a thiolene resin, a crosslinked poly(meth)acrylate, a crosslinked polyurethane, a crosslinked epoxy resin, a crosslinked vinyl polymer, a crosslinked silicone resin, or a combination thereof. The linear polymer may include a carboxylic acid-containing repeating unit.

The content of quantum dots and titanium dioxide ($TiO_2$) in the quantum dot composite is described above. The content of the matrix in the quantum dot composite may be greater than or equal to about 10%, greater than or equal to about 20%, greater than or equal to about 30%, greater than or equal to about 40%, greater than or equal to about 50%, or greater than or equal to about 60%. The content of the matrix in the quantum dot composite may be less than or equal to about 90%, less than or equal to about 80%, less than or equal to about 70%, less than or equal to about 60%, less than or equal to about 50%, or less than or equal to about 40%. The content of the total sum of quantum dots and titanium dioxide ($TiO_2$) in the quantum dot composite may be greater than or equal to about 10%, greater than or equal to about 20%, greater than or equal to about 30%, greater than or equal to about 40%, greater than or equal to about 50%, or greater than or equal to about 60%. The content of the matrix in the quantum dot composite may be less than or equal to about 90%, less than or equal to about 80%, less than or equal to about 70%, less than or equal to about 60%, less than or equal to about 50%, or less than or equal to about 40%.

The matrix may include the aforementioned dispersant (e.g., a carboxylic acid group-containing monomer or polymer), a polymerization product of a polymerizable monomer including at least one carbon-carbon double bond, for example 2 or more, 3 or more, 4 or more, or 5 or more, such as an insulating polymer, and optionally a polymerization product between the polymerizable monomer and thiol compounds having at least one, for example, two or more thiol groups at the terminal end.

In an embodiment, the polymer matrix may include a crosslinked polymer, a linear polymer, or a combination

thereof. The crosslinked polymer may include a thiolene resin, a crosslinked poly(meth)acrylate, or a combination thereof. In an embodiment, the crosslinked polymer may be a polymerization product of the aforementioned polymerizable monomer, and optionally a (multi) thiol compound. Details for the quantum dots, dispersants, polymerizable monomers, and descriptions of the (multi) thiol compound are the same as described above.

When the quantum dot composite according to an embodiment is applied to a display device with a light emitting panel including blue light with an emission peak of about 430 nm to about 470 nm as a light emitting source as described below, the light conversion efficiency of absorbing the blue light and converting it to green light or red light may be greater than or equal to about 25%, for example, greater than or equal to about 30%, for example, greater than or equal to about 35%, for example, greater than or equal to about 36%, for example, greater than or equal to about 38%, for example, greater than or equal to about 38.3%. As can be seen from the examples and the comparative examples to be described later, the light conversion efficiency is significantly increased in the examples in which the a quantum dot composite including quantum dots including a thinner shell, and thus, exhibit an increase in blue light absorption rate as well as a stabilized structure, which is an unexpectedly surprising effect achieved by the quantum dot composite including the quantum dots with a relatively thin shell though a composition adjusted to have specific optical density per unit weight.

In other words, the quantum dot composite according to an embodiment includes the quantum dots having an InP core and a ZnSe or ZnSeS shell disposed on the core, in which a thickness of a ZnSe or ZnSeS shell, which does not contribute to absorption of blue light, may not only be reduced, but also the thickness may be maintained within an appropriate thickness range for passivating and stabilizing defects on the surface of the quantum dots. Accordingly, the quantum dots according to an embodiment may have an excellent blue light absorption rate, for example, a blue light absorption rate of greater than or equal to about 80%, for example, greater than or equal to about 83%, for example, greater than or equal to about 84%, for example, greater than or equal to about 85%, for example, greater than or equal to about 90%, and simultaneously, greatly improved light conversion efficiency. Accordingly, the quantum dot composite according to an embodiment may be advantageously applied to a display panel and the like of a display device.

The display panel may include a color conversion layer including a plurality of regions including a color conversion region, and the quantum dot composite may be disposed in the color conversion region in the color conversion layer. In an embodiment, the color conversion layer may further include a partition wall defining the plurality of regions.

In an embodiment, the display panel may further include a light emitting panel including a light emitting source configured to emit blue light, a light emitting source configured to emit green light, or a combination thereof, and the color conversion layer may convert an emission spectrum of excitation light emitted from the light emitting panel. For example, the color conversion layer may absorb the blue light and convert it into green light or red light. In this case, the light conversion efficiency may be greater than or equal to about 30%, for example, greater than or equal to about 35%, for example, greater than or equal to about 36%, for example, greater than or equal to about 37%, for example, greater than or equal to about 38%, for example, greater than or equal to about 39%, and the blue light absorption rate may also be greater than or equal to about 80%. In addition, a display device to be described later including the display panel may have a BT2020 reference color gamut of greater than or equal to about 90%.

In an embodiment, the color conversion layer may be in a form of a patterned film.

In an embodiment, the color conversion region of the color conversion layer includes at least one first color conversion region (hereinafter also referred to as a first region or a first partition) configured to emit a first light following irradiation with the excitation light, and the first color conversion region includes the quantum dot composite according to an embodiment. The color conversion layer may be a patterned film of a quantum dot composite according to an embodiment.

The color conversion region may include a at least one second color conversion region (hereinafter also referred to as a second region or a second partition) configured to emit a second light different from the first light following irradiation with the excitation light and the second color conversion region may include a quantum dot composite according to an embodiment.

The quantum dot composite of the second color conversion region may include quantum dots that emit light of a different wavelength (e.g., a different color) from the quantum dot composite in the first color conversion region.

The first light or the second light may be red light having an emission peak wavelength of about 610 nm to about 660 nm (e.g., about 620 nm to about 650 nm), or green light having an emission peak wavelength of about 500 nm to about 550 nm (e.g., about 510 nm to about 540 nm). The color conversion layer may further include at least one third region (hereinafter also referred to as a third partition) that emits a third light (e.g., blue light) or allows light to pass through different from the first light and the second light. The third light may include excitation light. The third light may include blue light having an emission peak wavelength in a range of about 430 nm to about 470 nm. The third light may include blue-green light having an emission peak wavelength in a range of about 480 nm to about 500 nm. In an embodiment, the first emission spectrum may be a green emission spectrum having an emission peak wavelength between about 500 nm and about 550 nm and a weight ratio of a weight of selenium to a weight of titanium (Se/Ti) in a first color conversion region, the weight ratio Se/Te may be greater than or equal to about 2 and less than or equal to about 12. For example, the weight ratio of selenium to titanium (Se/Ti) in the first color conversion region may be greater

than or equal to about 2 and less than or equal to about 10, for example, greater than or equal to about 3 and less than or equal to about 10, but is not limited thereto.

In an embodiment, in the first color conversion region, may have a weight ratio of a weight of indium to a weight of titanium (In/Ti) may be greater than or equal to about 0.2 and less than or equal to about 1.8, and a weight ratio of a weight of phosphorus to a weight of (P/Ti may be greater than or equal to about 0.05 and less than or equal to about 0.4. For example, in the first color conversion region, a weight ratio of indium to titanium (In/Ti) may be greater than or equal to about 0.2 and less than or equal to about 1.7, for example, greater than or equal to about 0.2 and less than or equal to about 1.5, and a weight ratio of phosphorus to titanium (P/Ti) may be greater than or equal to about 0.1 and less than or equal to about 0.4, for example, greater than or equal to about 0.1 and less than or equal to about 0.3.

In an embodiment, the second emission spectrum may be a red emission spectrum having an emission peak wavelength between about 610 nm and about 660 nm and a weight ratio of Se to titanium (Se/Ti) in the second color conversion region may be greater than or equal to about 1 and less than or equal to about 5. For example, the weight ratio Se/Ti in the second color conversion region may be greater than or equal to about 1 and less than or equal to about 4, for example, greater than or equal to about 1.2 and less than or equal to about 3, but is not limited thereto.

In an embodiment, in the second color conversion region, a weight ratio of indium to titanium (In/Ti) may be greater than or equal to about 0.1 and less than or equal to about 0.5, and a weight ratio of a weight of P/Ti may be greater than or equal to about 0.05 and less than or equal to about 0.3. For example, in the second color conversion region, the weight ratio of In/Ti may be greater than or equal to about 0.1 and less than or equal to about 0.4, for example, greater than or equal to about 0.1 and less than or equal to about 0.3, for example, greater than or equal to about 0.1 and less than or equal to about 0.2, for example, greater than or equal to about 0.2 and less than or equal to about 0.4, and in the second color conversion region, the weight ratio of P/Ti may be greater than or equal to about 0.1 and less than or equal to about 0.3, for example, greater than or equal to about 0.1 and less than or equal to about 0.2, but is not limited thereto.

A content ratio of each element in each color conversion region may be measured by, for example, physically scraping off a predetermined area, such as a predetermined volume of a solid in each color conversion region including the quantum dots in the display panel, forming a powder from the scrapings, dissolving the powder in an acid, for example, nitric acid, bromic acid, hydrofluoric acid, and the like, to prepare a solution, and performing an ICP analysis of the acid solution. Herein, from the solution, a polymer constituting a polymer matrix forming a quantum dot composite included in each color conversion region, a light diffusing agent such as titanium dioxide and the like dispersed with the quantum dots in the polymer matrix, and various other components may be detected. In this case, while the titanium element may be derived only from the light diffusing agent, the other elements, such as, indium, phosphorus, selenium, and the like, are derived only from the quantum dots in the color conversion region. Accordingly, a content ratio between indium, phosphorus, or selenium and titanium, i.e., titanium from the titanium dioxide, is independent of the presence of other components used in the making of the quantum dots and the light diffusing agent included in each color conversion region. Accordingly, the contents or content ratios of the stated elements included in the color conversion region may quantitatively be analyzed. As described above, since the display panel according to an embodiment includes a quantum dot composite including the quantum dots according to an embodiment.

The color conversion layer (or the patterned film of the quantum dot composite) may be produced using a photoresist composition. This method may include forming a film of the aforementioned composition on a substrate (S1); prebaking the film according to selection (S2); exposing a selected region of the film to light (e.g., having a wavelength of less than or equal to about 400 nm) (S3); and developing the exposed film with an alkali developing solution to obtain a pattern of a quantum dot-polymer composite (S4).

Referring to FIG. 1A, the aforementioned composition is applied to a predetermined thickness on a substrate using an appropriate method such as spin coating or slit coating to form a film (S1). The formed film may be optionally subjected to a pre-baking (PRB) (S2). The pre-baking may be performed by selecting an appropriate condition from known conditions of a temperature, time, an atmosphere, and the like.

The formed (or optionally prebaked) film is exposed to light having a predetermined wavelength under a mask having a predetermined pattern (S3). A wavelength and intensity of the light may be selected considering types and contents of the photoinitiator, types and contents of the quantum dots, and the like.

The exposed film is treated with an alkali developing solution (e.g., dipping or spraying) to dissolve an unexposed region and obtain a desired pattern (S4). The obtained pattern may be, optionally, post-baked (POB) to improve crack resistance and solvent resistance of the pattern, for example, at a temperature of about 150 °C to about 230 °C for a predetermined time (e.g., greater than or equal to about 10 minutes or greater than or equal to about 20 minutes) (S5).

When the color conversion panel or the patterned film of the quantum dot composite has a plurality of repeating partitions (that is, color conversion regions), each repeating partition may be formed by preparing a plurality of compositions including quantum dots (e.g., red light-emitting quantum dots, green light-emitting quantum dots, or optionally, blue light-emitting quantum dots) having desired luminous properties (emission peak wavelength and the like) and repeating the aforementioned pattern-forming process as many times as necessary (e.g., 2 times or more, or 3 times

or more) for each composition, resultantly obtaining a quantum dot-polymer composite having a desired pattern. For example, the quantum dot-polymer composite may have a pattern of at least two repeating color partitions (e.g., RGB color partitions) (S6). This quantum dot-polymer composite pattern may be used as a photoluminescence type color filter in a display device.

The color conversion panel or the patterned film of the quantum dot composite may be produced using an ink composition configured to form a pattern in an inkjet manner. Referring to FIG. 1B, such a method may include preparing an ink composition, which would include the quantum dots according to an embodiment (S1), providing a substrate (e.g., with pixel areas patterned by electrodes and optionally banks, etc.) (S2), depositing the ink composition on the substrate (or the pixel region) to form, for example, a first quantum dot layer (or first region) (S3); and depositing an ink composition on the substrate (or the pixel region) to form, for example, a second quantum dot layer (or second region) (S4). The forming of the first quantum dot layer and the forming of the second quantum dot layer are simultaneously or sequentially carried out.

The depositing of the ink composition may be performed using an appropriate liquid drop discharger, for example an inkjet or nozzle printing system having an ink storage and at least one print head. The deposited ink composition may provide a first or second quantum dot layer through the solvent removal and polymerization by the heating. The method may provide a highly precise quantum dot-polymer composite film or patterned film for a short time by the simple method.

The aforementioned quantum dots or quantum dot composite (pattern) may be included in an electronic device. Such an electronic device may include, but are not limited to, a display device, a light emitting diode (LED), an organic light emitting diode (OLED), a quantum dot LED, a sensor, a solar cell, an imaging sensor, a photodetector, or a liquid crystal display device.

The aforementioned quantum dots may be included in an electronic apparatus. Such an electronic apparatus may include, but is not limited to, a portable terminal device, a monitor, a note PC, a television, an electric sign board, a camera, a car, and the like. The electronic apparatus may be a portable terminal device including a display device (or a light emitting device) including quantum dots, a monitor, a note PC, or a television. The electronic apparatus may be a camera or a mobile terminal device including an image sensor including quantum dots. The electronic apparatus may be a camera or a vehicle including a photodetector including quantum dots.

In an embodiment, the electronic device or display device (e.g., display panel) may further include the color conversion panel, and optionally, a light source. In an embodiment, the display panel may include a light emitting panel (or a light source), a color conversion panel, and a light transmitting layer between the light emitting panel and the color conversion panel. The color conversion panel may include a substrate, and the color conversion layer may be disposed on the substrate.

The light source or the light emitting panel (if present) may be configured to provide incident light to the light emitting element. The incident light may have an emission peak wavelength in the range of greater than or equal to about 430 nm, for example, greater than or equal to about 440 nm, or greater than or equal to about 450 nm, and less than or equal to about 470 nm, for example, less than or equal to about 460 nm.

In an embodiment, the color conversion panel or the device (e.g., a photoluminescence type device) may include a sheet of the quantum dot composite according to an embodiment. Referring to FIG. 2, the device includes a backlight unit and a liquid crystal panel (LC), and the backlight unit may include a quantum dot-polymer composite sheet (QD sheet). Specifically, the backlight unit may have a structure in which a reflector, a light guide plate (LGP), a light source (blue LED, etc.), a quantum dot-polymer composite sheet (QD sheet), and an optical film (prism, double brightness enhancing film (DBEF), etc.) are stacked. The liquid crystal panel (LC) is disposed on the backlight unit and may have a structure including a liquid crystal and a color filter between two polarizers (Pol). The quantum dot-polymer composite sheet (QD sheet) may include quantum dots emitting red light and quantum dots emitting green light by absorbing light from a light source. Blue light from the light source may be combined with red light and green light emitted from quantum dots and converted to white light by passing through the quantum dot-polymer composite sheet. The white light may be separated to blue light, green light, and red light by a color filter in the liquid crystal panel and may be emitted to the outside in each pixel.

The color conversion panel may include a substrate, and the color conversion layer may be disposed on the substrate.

The color conversion layer or the color conversion panel may include a patterned film of the quantum dot composite. The patterned film includes repeating partitions configured to emit desired light. The repeating partition may include a first partition. The second partition may include a green light emitting partition. The third partition may be a partition that emits or transmits blue light. Details of the first, second, and third partitions are the same as described above.

The light emitting panel or the light source may be an element emitting excitation light. The excitation light may include blue light and/or green light. The light source may include an LED. The light source may include an organic LED (OLED). On the front surface (light emitting surface) of the first partition and the second partition, an optical element to block (e.g., reflect or absorb) blue light (and optionally green light) for example, a blue light (and optionally green light)

blocking layer or a first optical filter that will be described later may be disposed. When the light source includes organic light emitting diode to emit blue light and an organic light emitting diode to emit green light, a green light removing filter may be further disposed on a third partition through which blue light is transmitted.

The light emitting panel or the light source may include a plurality of light emitting units respectively corresponding to the first partition and the second partition, and the light emitting unit may include a first electrode and a second electrode facing each other, and an (organic) electroluminescent layer between the first electrode and the second electrode. The electroluminescent layer may include an organic light emitting material. For example, each light emitting unit of the light source may include an electroluminescent device (e.g., an organic light emitting diode) configured to emit light of a predetermined wavelength (e.g., blue light, green light, or a combination thereof). The structures and materials of the electroluminescent device and the organic light emitting diode are known, and are not particularly limited.

Hereinafter, the display panel and the color conversion panel will be described in more detail with reference to the drawings.

Referring to FIGS. 3 and 4, a display panel 1000 according to an embodiment includes a light emitting panel 100, a color conversion panel 200, a light transmitting layer 300 disposed between the light emitting panel 100 and the color conversion panel 200, and a binder (hereinafter, also referred to as binding element) 400 bonding the light emitting panel 100 and the color conversion panel 200.

The light emitting panel 100 and the color conversion panel 200 may face each other with the light transmitting layer 300 therebetween, and the color conversion panel 200 may be disposed in a direction in which light is emitted from the light emitting panel 100. The binder 400 may be disposed along the edges of the light emitting panel 100 and the color conversion panel 200, and may be, for example, a sealant.

In FIGS. 3 and 4, the light transmitting layer 300 is disposed between the light emitting panel 100 and the color conversion panel 200, and the binder 400 is disposed along the edges of the light emitting panel 100 and the color conversion panel 200. However, the light transmitting layer 300 and the binder 400 may be omitted and are not necessarily included. That is, the light emitting panel 100 and the color conversion panel 200 may be directly coupled without interposing the light transmitting layer 300.

Referring to FIG. 5, a display panel 1000 according to an embodiment includes a display area 1000D for displaying an image and a non-display area 1000P disposed around the display area 1000D and in which the binding element 400 is disposed.

The display area 1000D may include a plurality of pixels PXs arranged along a row (e.g., x direction) and/or a column (e.g., y direction), and each pixel PX may include a plurality of subpixels $PX_1$, $PX_2$, and $PX_3$ displaying different colors. Herein, as an example, a configuration in which three subpixels $PX_1$, $PX_2$, and $PX_3$ constitute one pixel PX is illustrated, but the configuration is not limited thereto. An additional subpixel such as a white subpixel may be further included, and one or more subpixel displaying the same color may be included. The plurality of pixels PXs may be arranged in, for example, a Bayer matrix, a PenTile matrix, and/or a diamond matrix, but is not limited thereto.

Each of the subpixels $PX_1$, $PX_2$, and $PX_3$ may be configured to display a color of three primary colors or a combination of three primary colors, for example, red, green, blue, or a combination thereof. For example, the first subpixel $PX_1$ may be configured to display red, the second subpixel $PX_2$ may be configured to display green, and the third subpixel $PX_3$ may be configured to display blue.

In the drawing, an example in which all subpixels have the same size is illustrated, but the present disclosure is not limited thereto. At least one of the subpixels may be larger or smaller than the other subpixels. In the drawing, an example in which all subpixels have the same shape is illustrated, but the present disclosure is not limited thereto. At least one of the subpixels may have a different shape from other subpixels.

FIGS. 6A and 6B are schematic cross-sectional views of devices (or display panels) according to embodiments. Referring to FIGS. 6A and 6B, the light source (or light emitting panel) includes an organic light emitting diode that emits blue light (and optionally green light). The organic light emitting diode (OLED) may include at least two pixel electrodes formed on the substrate, a pixel define layer formed between the adjacent pixel electrodes, an organic light emitting layer formed on each pixel electrode, and a common electrode layer formed on the organic light emitting layer. A thin film transistor and a substrate may be disposed under the organic light emitting diode (OLED). The pixel area of the OLED may be disposed to correspond to first, second, and third partitions to be described later.

A stacked structure including the quantum dot composite pattern (e.g., a first partition including red quantum dots and a second partition including green quantum dots) and substrate may be disposed on the light source. The blue light emitted from the light source enters the first partition and second partition and emits red light and green light, respectively. The blue light emitted from the light source may pass through the third partition. An element (first optical filter or excitation light blocking layer) configured to block the excitation light may be disposed between the quantum dot composite layers R and G and the substrate, as needed. When the excitation light includes blue light and green light, a green light blocking filter may be added to the third partition. The first optical filter or the excitation light blocking layer will be described in more detail later.

Such a device may be produced by separately producing the aforementioned color conversion panel and an

LED or OLED (e.g., emitting blue light and optionally green light) and then combining them. Alternatively, the device may be produced by directly forming the quantum dot composite pattern on the LED or OLED.

The substrate may be a substrate including an insulation material. The substrate may include glass; various polymers such as a polyester of polyethylene terephthalate (PET), polyethylene naphthalate (PEN), and the like, polycarbonate, and polyacrylate; polysiloxane (e.g. PDMS); an inorganic material such as $Al_2O_3$ or ZnO; or a combination thereof, but is not limited thereto. A thickness of the substrate may be appropriately selected considering a substrate material but is not particularly limited. The substrate may have flexibility. The substrate may have a transmittance of greater than or equal to about 50%, greater than or equal to about 60%, greater than or equal to about 70%, greater than or equal to about 80%, or greater than or equal to about 90% for light emitted from the quantum dots.

A wire layer including a thin film transistor or the like is formed on the substrate. The wire layer may further include a gate line, a sustain voltage line, a gate insulating layer, a data line, a source electrode, a drain electrode, a semiconductor, a protective layer, and the like. The detailed structure of the wire layer may vary depending on an embodiment. The gate line and the sustain voltage line are electrically separated from each other, and the data line is insulated and crossing the gate line and the sustain voltage line. The gate electrode, the source electrode, and the drain electrode form a control terminal, an input terminal, and an output terminal of the thin film transistor, respectively. The drain electrode is electrically connected to the pixel electrode that will be described later.

The pixel electrode may function as an electrode (e.g., anode) of the display device. The pixel electrode may be formed of a transparent conductive material such as indium tin oxide (ITO) or indium zinc oxide (IZO). The pixel electrode may be formed of a material having a light-blocking property such as gold (Au), platinum (Pt), nickel (Ni), tungsten (W), chromium (Cr), molybdenum (Mo), iron (Fe), cobalt (Co), copper (Cu), palladium (Pd), or titanium (Ti). The pixel electrode may have a two-layered structure where the transparent conductive material and the material having light-blocking properties are stacked sequentially.

Between two adjacent pixel electrodes, a pixel define layer (PDL) overlapped with a terminal end of the pixel electrode to divide the pixel electrode into a pixel unit. The pixel define layer is an insulation layer which may electrically block the at least two pixel electrodes.

The pixel define layer covers a portion of the upper surface of the pixel electrode, and the remaining region of the pixel electrode where is not covered by the pixel define layer may provide an opening. An organic light emitting layer that will be described later may be formed in the region defined by the opening.

The organic light emitting layer defines each pixel area by the aforementioned pixel electrode and the pixel define layer. In other words, one pixel area may be defined as an area where is formed with one organic light emitting unit layer which is contacted with one pixel electrode divided by the pixel define layer. In the display device according to an embodiment, the organic light emitting layer may be defined as a first pixel area, a second pixel area and a third pixel area, and each pixel area is spaced apart from each other leaving a predetermined interval by the pixel define layer.

In an embodiment, the organic light emitting layer may emit a third light belong to visible light region or belong to UV region. Each of the first to the third pixel areas of the organic light emitting layer may emit third light. In an embodiment, the third light may be a light having the highest energy in the visible light region, for example, may be blue light (and optionally green light). When all pixel areas of the organic light emitting layer are designed to emit the same light, each pixel area of the organic light emitting layer may be all formed of the same or similar materials or may show the same or similar properties. Thus, it may greatly relieve a process difficulty of forming the organic light emitting layer, and thus the display device may be easily applied for the large scale/large area process. However, the organic light emitting layer according to an embodiment is not necessarily limited thereto, but the organic light emitting layer may be designed to emit at least two different lights.

The organic light emitting layer includes an organic light emitting unit layer in each pixel area, and each organic light emitting unit layer may further include an auxiliary layer (e.g., hole injection layer, hole transport layer, electron transport layer, etc.) besides the light emitting layer.

The common electrode may function as a cathode of the display device. The common electrode may be formed of a transparent conductive material such as indium tin oxide (ITO) or indium zinc oxide (IZO). The common electrode may be formed on the organic light emitting layer and may be integrated therewith.

A planarization layer or a passivation layer (not shown) may be formed on the common electrode. The planarization layer may include a (e.g., transparent) insulating material for ensuring electrical insulation with the common electrode.

In an embodiment, the display device may further include a lower substrate, a polarizing plate disposed under the lower substrate, and a liquid crystal layer disposed between the stacked structure and the lower substrate, and in the stacked structure, the light emitting layer may be disposed to face the liquid crystal layer. The display device may further include a polarizing plate between the liquid crystal layer and the light emitting layer. The light source may further include LED and if necessary, a light guide plate.

Non-limiting examples of the display device (e.g., a liquid crystal display device) according to an embodiment are illustrated with a reference to a drawing. FIG. 7 is a schematic cross-sectional view showing a liquid crystal display

according to an embodiment. Referring to FIG. 7, the display device of an embodiment includes a liquid crystal panel 200, a polarizing plate 300 disposed under the liquid crystal panel 200, and a backlight unit (BLU) disposed under the polarizing plate 300.

The liquid crystal panel 200 includes a lower substrate 210, a stacked structure, and a liquid crystal layer 220 disposed between the stack structure and the lower substrate. The stacked structure includes a transparent substrate 240 and a photoluminescent layer 230 including a pattern of a quantum dot-polymer composite.

The lower substrate 210 referred to as an array substrate may be a transparent insulation material substrate. The substrate is the same as described above. A wire plate 211 is provided on an upper surface of the lower substrate 210. The wire plate 211 may include a plurality of gate lines (not shown) and data lines (not shown) that define a pixel area, a thin film transistor disposed adjacent to a crossing region of gate lines and data lines, and a pixel electrode for each pixel area, but is not limited thereto. Details of such a wire plate are known and are not particularly limited.

A liquid crystal layer 220 is provided on the wire plate 211. The liquid crystal panel 200 may include an alignment layer 221 on and under the liquid crystal layer 220 to initially align the liquid crystal material included therein. Details (e.g., a liquid crystal material, an alignment layer material, a method of forming liquid crystal layer, a thickness of liquid crystal layer, or the like) of the liquid crystal layer and the alignment layer are known and are not particularly limited.

A polarizing plate 300 is provided under the lower substrate. Materials and structures of the polarizing plate 300 are known and are not particularly limited. A backlight unit (e.g., emitting blue light) may be disposed under the polarizing plate 300. An upper optical element or the polarizing plate 300 may be provided between the liquid crystal layer 220 and the transparent substrate 240 but is not limited thereto. For example, the polarizing plate may be disposed between the liquid crystal layer 220 and the photoluminescent layer 230. The polarizing plate may be any polarizer that can be used in a liquid crystal display device. The polarizing plate may be TAC (triacetyl cellulose) having a thickness of less than or equal to about 200 μm but is not limited thereto. In another embodiment, the upper optical element may be a coating that controls a refractive index without a polarization function.

The backlight unit includes a light source 110. The light source may emit blue light or white light. The light source may include, but is not limited to, a blue LED, a white LED, a white OLED, or a combination thereof.

The backlight unit may further include a light guide plate 120. In an embodiment, the backlight unit may be of an edge type. For example, the backlight unit may include a reflector (not shown), a light guide plate (not shown) provided on the reflector and providing a planar light source with the liquid crystal panel 200, and/or at least one optical sheet (not shown) on the light guide plate, for example, a diffusion plate, a prism sheet, and the like, but is not limited thereto. The backlight unit may not include a light guide plate. In an embodiment, the backlight unit may be direct lighting. For example, the backlight unit may have a reflector (not shown) and may have a plurality of fluorescent lamps disposed on the reflector at regular intervals, or may have an LED operating substrate on which a plurality of light emitting diodes may be disposed, a diffusion plate thereon, and optionally at least one optical sheet. Details (e.g., each component of a light emitting diode, a fluorescent lamp, a light guide plate, various optical sheets, and a reflector) of such a backlight unit are known and are not particularly limited.

A black matrix 241 is provided under the transparent substrate 240 and has openings and hides a gate line, a data line, and a thin film transistor of the wire plate on the lower substrate. For example, the black matrix 241 may have a grid shape. The color conversion layer is provided in the opening of the black matrix 241 and has a photoluminescent layer 230 having a quantum dot-polymer composite pattern including a first partition R configured to emit first light (e.g., red light), a second partition G configured to emit second light (e.g., green light), and a third partition B configured to emit/transmit, for example blue light. If needed, the photoluminescent layer may further include at least one fourth partition. The fourth partition may include a quantum dot that emits light of different color from light emitted from the first to third partitions (e.g., cyan, magenta, and yellow light).

In the photoluminescent layer 230, partitions forming the pattern may be repeated corresponding to pixel areas formed on the lower substrate. A transparent common electrode 231 may be provided on the photoluminescent layer 230.

The third partition B configured to emit/transmit blue light may be a transparent color filter that does not change the emission spectrum of the light source. In this case, blue light emitted from the backlight unit may enter in a polarized state and may be emitted through the polarizing plate and the liquid crystal layer as it is. If needed, the third partition may include a quantum dot emitting blue light.

As described above, if desired, the display device or light emitting device according to an embodiment may further include an excitation light blocking layer or a first optical filter layer (hereinafter, referred to as a first optical filter layer). The first optical filter layer may be disposed between the bottom surface of the first partition R and the second partition G and the substrate (e.g., the transparent substrate 240) or on the upper surface of the transparent substrate 240. The first optical filter layer may be a sheet having an opening in a portion corresponding to a pixel region (third partition) displaying blue, and thus may be formed in portions corresponding to the first and second partitions. That is, the first optical filter layer may be integrally formed at positions other than the position overlapped with the third partition as shown in FIGS. 6A, 6B, and 7, but is not limited thereto. Two or more first optical filter layers may be spaced apart from each other at positions overlapped with the first and second partitions, and optionally, the third partition. When the

light source includes a green light emitting element, a green light blocking layer may be disposed on the third partition.

The first optical filter layer may block light having, for example, a predetermined wavelength region in the visible light region and may transmit light in the other wavelength regions, and for example, it may block blue light (or green light) and may transmit light except the blue light (or green light). The first optical filter layer may transmit, for example, green light, red light, and/or yellow light which is a mixed color thereof. The first optical filter layer may transmit blue light and block green light and may be disposed on the blue light emitting pixel.

The first optical filter layer may substantially block excitation light and transmit light in a desired wavelength region. The transmittance of the first optical filter layer for the light in a desired wavelength range may be greater than or equal to about 70%, greater than or equal to about 80%, greater than or equal to about 90%, or even about 100%.

The first optical filter layer configured to selectively transmit red light may be disposed at a position overlapped with the red light emitting partition, and the first optical filter layer configured to selectively transmit green light may be disposed at a position overlapped with the green light emitting partition. The first optical filter layer may include at least one of a first region that blocks (e.g., absorb) blue light and red light and selectively transmits light of a predetermined range (e.g., greater than or equal to about 500 nm, greater than or equal to about 510 nm, or greater than or equal to about 515 nm and less than or equal to about 550 nm, less than or equal to about 545 nm, less than or equal to about 540 nm, less than or equal to about 535 nm, less than or equal to about 530 nm, less than or equal to about 525 nm, or less than or equal to about 520 nm), and a second region that blocks (e.g., absorb) blue light and green light and selectively transmits light of a predetermined range (e.g., greater than or equal to about 600 nm, greater than or equal to about 610 nm, or greater than or equal to about 615 nm and less than or equal to about 650 nm, less than or equal to about 645 nm, less than or equal to about 640 nm, less than or equal to about 635 nm, less than or equal to about 630 nm, less than or equal to about 625 nm, or less than or equal to about 620 nm). When the light source emits blue and green mixed light, the first optical filter layer may further include a third region that selectively transmits blue light and blocks green light.

The first region may be disposed at a position overlapped with the green light emitting partition. The second region may be disposed at a position overlapped with the red light emitting partition. The third region may be disposed at a position overlapped with the blue light emitting partition.

The first region, the second region, and, optionally, the third region may be optically isolated. Such a first optical filter layer may contribute to improvement of color purity of the display device.

The display device may further include a second optical filter layer (e.g., recycling layer of red/green light or yellow light) that is disposed between the photoluminescent layer and the liquid crystal layer (e.g., between the photoluminescent layer and the polarizing plate), transmits at least a portion of the third light (excitation light), and reflects at least a portion of the first light and/or the second light. The first light may be red light, the second light may be green light, and the third light may be blue light. The second optical filter layer may transmit only the third light (B) in a blue light wavelength region having a wavelength region of less than or equal to about 500 nm and light in a wavelength region of greater than about 500 nm, which is green light (G), yellow light, red light (R), or the like, may be not passed through the second optical filter layer 140 and reflected. The reflected green light and red light may pass through the first and second partitions and to be emitted to the outside of the display device.

The second optical filter layer or the first optical filter layer may be formed as an integrated layer having a relatively planar surface.

The first optical filter layer may include a polymer thin film including a dye and/or a pigment absorbing light in a wavelength which is to be blocked. The second optical filter layer and the first optical filter layer may include a single layer having a low refractive index, and may be, for example, a transparent thin film having a refractive index of less than or equal to about 1.4, less than or equal to about 1.3, or less than or equal to about 1.2. The second optical filter layer or the first optical filter layer having a low refractive index may be, for example, a porous silicon oxide, a porous organic material, a porous organic-inorganic composite, or a combination thereof.

The first optical filter layer or the second optical filter layer may include a plurality of layers having different refractive indexes. It may be formed by stacking two layers having different refractive indexes. For example, the first/second optical filter layer may be formed by alternately stacking a material having a high refractive index and a material having a low refractive index.

Hereinafter, the embodiments are illustrated in more detail with reference to examples. However, they are exemplary examples of the present disclosure, and the present disclosure is not limited thereto.

Examples

Analysis Methods

[1] UV-Vis Spectroscopy

UV spectroscopy is performed by using an Agilent Cary5000 spectrometer to obtain a UV-Visible absorption spectrum.

[2] Photoluminescence Analysis

A Hitachi F-7000 spectrometer is used to obtain photoluminescence (PL) spectra of the produced quantum dots at excitation wavelength of 450 nm.

[3] ICP Analysis

Shimadzu ICPS-8100 is used to perform inductively coupled plasma-atomic emission spectrometry (ICP-AES).

[4] Blue Light Absorption Rate and Light Conversion Efficiency for Composites

An amount of blue excitation light (B) is measured using an integrating sphere. The quantum dot polymer composite is positioned in the integrating sphere and the blue excitation light is irradiated to measure the amount of red light (A) and the amount of blue light (B') emitted from the composite.
From the measured values, the blue light absorption rate and light conversion efficiency are obtained by the following equations.

$$\text{Blue light absorption rate (\%)} = (B-B')/B \times 100$$

$$\text{Light conversion efficiency (\%)} = A/B \times 100$$

[5] Transmission electron Microscope Analysis

TEM analysis is performed using a UT F30 Tecnai electron microscope.

[6] Measurement of Optical Density

10 microliters (μl) of the crude quantum dots is diluted in 990 μl of toluene and added to a 1 ml cuvette having a 1 cm optical path. Optical density is measured in a wavelength range of 300 nm to 700 nm by using UV-Vis absorption spectroscopy (Shimadzu UV-2600).

Synthesis Example 1: Preparation of InP Core

InP semiconductor nanocrystal particles (hereinafter, at times, also referred to as a core) are prepared in the following manner.
In a 200 milliliters (mL) reaction flask, indium acetate and palmitic acid are added to 1-octadecene and heated at 120 °C under vacuum. The moles of indium to moles of palmitic acid is about 1 to 3. After 1 hour, nitrogen is introduced into the flask. The reaction flask temperature is increased to 280 °C, and then, a mixed solution of tris(trimethylsilyl)phosphine (TMS3P) and trioctylphosphine is rapidly injected into the flask and reacted for 20 minutes. After the reaction solution is allowed to cool to room temperature, acetone is then added and the resulting precipitate is separated by centrifuge and dispersed in toluene. The TMS3P is used in an amount of 0.5 moles per 1 mole of indium. A size of the obtained InP core is about 2 nm.

Synthesis Example 2: Preparation of InP Core

InP semiconductor nanocrystal particles (hereinafter, at times, also referred to as core) are prepared in the following manner.

In a 200 mL reaction flask, indium acetate and palmitic acid are added to 1-octadecene and heated at 120 °C under vacuum. The moles of indium to moles of palmitic acid is about 1 to 3. After 1 hour, nitrogen is introduced into the reaction flask. The reaction flask temperature is increased to 280 °C, and then, a mixed solution of tris(trimethylsilyl)phosphine (TMS3P) and trioctylphosphine is rapidly injected into the flask and reacted for 20 minutes. The reaction solution is allowed to cool to room temperature, acetone is then added, and the resulting precipitate is separated by centrifuge and dispersed in toluene. The TMS3P is used in an amount of 0.75 moles per 1 mole of indium. A size of the obtained InP core is about 3.6 nm.

Example 1: Production of Green Quantum Dots (InP/ZnSe/ZnS) and Quantum Dot Composites and Characteristic Analysis

[1] Synthesis of Quantum Dot and Measurement of Optical Density

(1) Selenium is dispersed in trioctylphosphine to prepare a Se/TOP stock solution, and sulfur is dispersed in trioctylphosphine to prepare a S/TOP stock solution.

In a 200 mL reaction flask, 24 millimoles (mmols) of zinc acetate and oleic acid are added to trioctylamine and the mixture vacuum-treated at 120 °C for 10 minutes. Nitrogen is introduced into the reaction flask and the toluene dispersion of the InP core synthesized in Synthesis Example 1 is injected as the temperature of the obtained solution is increased to 320 °C. The prepared Se/TOP stock solution is injected in several separate additions into the heated reaction flask. The reaction is performed to obtain a reaction solution including particles having a ZnSe shell disposed on the core. A total reaction time is approximately 100 minutes, and about 23 moles of Se are used per 1 mole of indium.

At a reaction temperature of 320 °C, the S/TOP stock solution is injected into the reaction solution. The reaction is performed to obtain a reaction solution including particles in which the ZnS shell is disposed on the ZnSe shell. The total reaction time is 60 minutes, and about 13 moles of S are used for 1 mole of indium. Thereafter, the solution is allowed to cool to room temperature, an excess of ethanol is added, and the resulting precipitate in separated by centrifuge. The supernatant is discarded and the collected precipitate is dried and dispersed in toluene to obtain an InP/ZnSe/ZnS quantum dot solution.

(2) The quantum dot solution prepared in (1) is added to a cuvette having a 1 cm optical path in a UV-Vis absorption spectroscopy device (UV-2600, Shimadzu Corp.) and the optical density (OD) is measured per unit weight of the obtained quantum dots (QD), and the results are shown in FIG. 8 and Table 1.

[2] Production of Quantum Dot-Polymer Composite and Pattern Thereof

(1) Preparation of Quantum Dot-Binder Dispersion

The quantum dot-toluene dispersion prepared in [1] above is mixed with a binder (a quaternary copolymer of methacrylic acid, benzyl methacrylate, hydroxyethylmethacrylate, and styrene, having an acid value of 130 mg KOH/g, a molecular weight: 8000) to provide a quantum dot-binder dispersion (concentration of the binder: 30 wt% in propylene glycol monomethyl ether acetate).

(2) Preparation of Photosensitive Composition

The quantum dot binder dispersion is mixed with hexacrylate having the following structure as a photopolymerizable monomer, glycoldi-3-mercaptopropionate (hereinafter, 2T), an oxime ester compound as an initiator, and $TiO_2$ as a light diffusing agent, and PGMEA to prepare a composition.

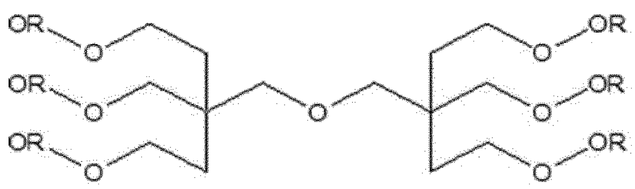

OR= 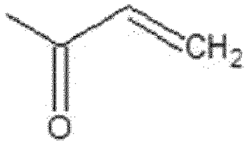

The prepared composition includes 42 weight percent (wt%) of the quantum dots, 17.5 wt% of the binder polymer, 3 wt% of $TiO_2$, 25 wt% of 2T, 12 wt% of the photopolymerizable monomer, and 0.5 wt% of the initiator based on a solid weight of the composition. The total solid content (TSC) is 25 wt%.

(3) Production of Quantum Dot-Polymer Composite Pattern and Characteristic Analysis

The photosensitive composition obtained in (2) is spin-coated on a glass substrate at 150 rpm for 5 seconds to obtain a film. The obtained film is prebaked (PRB) at 100 °C for 2 minutes. The prebaked film is irradiated with light (wavelength: 365 nm and intensity: 100 millijoules (mJ) for 1 second under a mask having a predetermined pattern (e.g., square dot or stripe pattern), and post-baking (POB) at 180 °C for 30 minutes. Then, the film is developed with an aqueous potassium hydroxide solution (concentration: 0.043%) for 50 seconds to provide a patterned quantum dot-polymer composite film (e.g., QD C/F film) having a thickness of about 10 micrometers (μm).

For the film, an emission spectrum (photoluminescence: PL) at an excitation wavelength of 450 nm is measured using a Hitachi F-7000 spectrometer, and an emission peak wavelength and full width at half maximum (FWHM) are determined from the PL spectrum. In addition, using the Otsuka QE-2100 quantum efficiency measuring system (manufacturer: Otsuka Electronics Co., Ltd.), blue light absorption rate and light conversion efficiency of the film are measured. The measured results are shown in Table 1.

To determine the relative mole or weight content of each element in the quantum dot-polymer composite film, the film is dissolved in nitric acid, bromic acid, or hydrofluoric acid to obtain a solution, and an ICP analysis is conducted. From the ICP analysis the relative content (e.g., weight or moles) of each element is used to calculate a weight ratio (or mole ratio) of each element based on the weight (or moles) of titanium in the composite and the results are shown in Table 2.

Example 2: Production of Green Quantum Dots (InP/ZnSeS), Quantum Dot Composites, and Characteristic Analysis

[1] Synthesis of Quantum Dot and Measurement of Optical Density

(1) Selenium is dispersed in trioctylphosphine to prepare a Se/TOP stock dispersion, and sulfur is dispersed in trioctylphosphine to prepare a S/TOP stock dispersion.

In a 200 mL reaction flask, 24 mmols of zinc acetate and oleic acid are added to trioctylamine and vacuum-treated at 120 °C for 10 minutes. Nitrogen is introduced into the reaction flask, and the temperature of the reaction flask is increased to 280 °C. The toluene dispersion of the InP core synthesized in Synthesis Example 1 is then injected into the flask. Over several separate additions (injections), the Se/TOP and dodecanethiol are injected into the reaction flask as the temperature of the flask is maintained at 280 °C. The reaction provides a reaction solution including particles having a ZnSeS shell disposed on the core. The total reaction time is approximately 30 minutes, and 7 moles of Se are used per 1 mole of indium, and the relative content of dodecanethiol (DDT) is 2 moles.

Thereafter, the solution is allowed to cool to room temperature, an excess of ethanol is added and the resulting precipitate is separated by centrifuge. The supernatant is discarded, the precipitate is dried, and dispersed in toluene to obtain an InP/ZnSeS quantum dot solution.

(2) OD is measured in the same manner as in Example 1 using the prepared quantum dot solution, and the results are shown in FIG. 8 and Table 1.

[2] Production of Quantum Dot-Polymer Composite and Pattern thereof

The quantum dots prepared in [1] are used to produce a pattern film of a quantum dot-polymer composite in the same manner as [2] of Example 1, and the pattern film is measured with respect to an emission peak wavelength, a full width at half maximum (FWHM), a blue light absorption rate, and light conversion efficiency, and the results are shown in Table 1. In addition, a weight of each element in the film is measured in the same manner as Example 1 and used to calculate a weight ratio of each element based on the weight of titanium in the film. The results are shown in Table 2.

Example 3: Production of Red Quantum Dots (InP/ZnSe/ZnS), Quantum Dot Composites, and Characteristic Analysis

Quantum dots are prepared in a similar manner as in Example 1 except that the InP core of Synthesis Example 2 is used instead of the InP core of Synthesis Example 1. Accordingly, the quantum dots of Example 3 emit red light instead of green light of Example 2. The quantum dots are measured with respect to optical density in the same manner as Example 1 and the results are shown in Table 1.

In addition, the quantum dots are used in the same manner as described in [2] of Example 1 to form a pattern film of a quantum dot-polymer composite, and this film is measured with respect to an emission peak wavelength, a full width at half maximum (FWHM), a blue light absorption rate, and light conversion efficiency. The results are shown in Table 1. Furthermore, a weight of each element in the film is measured as with Example 1, and used to calculate a weight ratio of each element based on the weight of titanium in the film. The results are shown in Table 2.

Comparative Example 1: Production of Green Quantum Dots (InP/ZnSe/ZnS) with Reduced ZnSe Shell Thickness and Quantum Dot Composites and Characteristic Analysis

Green quantum dots are prepared in the same manner as in Example 1 except that the ZnSe shell thickness is reduced to increase optical density (OD) per weight, and the optical density per weight is shown in Table 1.

The quantum dots are used to form a pattern film of a quantum dot-polymer composite in the same manner as described in [2] of Example 1, and the film is measured with respect to an emission peak wavelength, a full width at half maximum (FWHM), a blue light absorption rate, and light conversion efficiency. The results are shown in Table 1. A relative weight of each element in the film is determined in the same manner as Example 1 and used to calculate a weight ratio of the weight of each element based on the weight of titanium in the film. The results are shown in Table 2.

Comparative Example 2: Production of Green Quantum Dots (InP/ZnSe/ZnS) with Reduced ZnS Shell Thickness and Quantum Dot Composites and Characteristic Analysis

Green quantum dots are prepared in the same manner as Example 1 except that the thickness of the ZnS shell is reduced to increase optical density (OD) per unit weight, and the result is shown in Table 1.

The quantum dots are used in the same manner as described in [2] of Example 1 to form a pattern film of a quantum dot-polymer composite, and this pattern film of the quantum dot-polymer composite is measured with respect to an emission peak wavelength, a full width at half maximum (FWHM), a blue light absorption rate, and light conversion efficiency. The results are shown in Table 1. A relative weight of each element in the film is measured in the same method as Example 1 and used to calculate a weight ratio of each element based on the weight of titanium element. The results are shown in Table 2.

Comparative Example 3: Production of Green Quantum Dots (InP/ZnSeS) with Increased ZnSeS Shell Thickness, Quantum Dot Composites, and Characteristic Analysis

Green quantum dots are prepared in the same method as Example 2 except that the ZnSeS shell thickness is increased to decrease optical density (OD) per unit weight and then, measured with respect to optical density per unit weight, and the results are shown in Table 1.

The quantum dots are used in the same manner as described in [2] of Example 1 to form a pattern film of a quantum dot-polymer composite, and this film is measured with respect to an emission peak wavelength, a full width at half maximum (FWHM), a blue light absorption rate, and light conversion efficiency. The results are shown in Table 1. A relative weight of each element is determined in the same method as in Example 1 and used to calculate a weight ratio of each element based on the weight of titanium in the film, and the results are shown in Table 2.

Table 1

| | Optical density (OD) /QD 1mg | | Characteristics of quantum dot composites for excitation light of 450 nm | | | |
|---|---|---|---|---|---|---|
| | @450 nm | @460 nm | Emission peak wavelength | Full width at half maximum (FWHM) | Lightconversion efficiency | Absorption rate |
| Example 1 | 0.222 | 0.139 | 537 nm | 34 nm | 35.7% | 84.4% |
| Example 2 | 0.269 | 0.33 | 539 nm | 39 nm | 36.2% | 84.7% |
| Example 3 | 0.521 | 0.446 | 642 nm | 36 nm | 38.30% | 95.6% |

(continued)

| | Optical density (OD) /QD 1mg | | Characteristics of quantum dot composites for excitation light of 450 nm | | | |
|---|---|---|---|---|---|---|
| | @450 nm | @460 nm | Emission peak wavelength | Full width at half maximum (FWHM) | Lightconversion efficiency | Absorption rate |
| Comp. Example 1 | 0.364 | 0.468 | 534 nm | 37 nm | 33.9% | 86.0% |
| Comp. Example 2 | 0.385 | 0.492 | 544 nm | 44 nm | 24.4% | 87.5% |
| Comp. Example 3 | 0.190 | 0.492 | 533 nm | 38 nm | 33.8% | 78.5% |

As shown in Table 1, the quantum dot composites according to Examples 1 and 2, each of which includes quantum dots having an OD at a wavelength of 450 nm in a range of 0.2 to 0.3 per 1 mg of the quantum dots and an emission peak wavelength from about 500 nm to about 550 nm. The quantum dot composite of Example 3 having an OD at a wavelength of 450 nm in a range of 0.5 to 0.7 per 1 mg and an emission peak wavelength in a range of about 610 nm to about 660 nm. Each of Examples 1, 2, and 3 exhibit excellent light conversion efficiency, even when the blue light absorption rate is slightly decreased, in comparison with the quantum dot composites of Comparative Examples 1, 2, and 3. Comparative Examples 1 and 2, which include a core and a shell having the same composition as Example 1, exhibit a blue light absorption rate of greater than or equal to 80%, light conversion efficiency of less than 35%, and an OD out of the above range.

In other words, light conversion efficiency of the quantum dot composite may not be increased by simply reducing a shell thickness, and instead, there is a specific shell thickness range where the light conversion efficiency is increased, while the blue light absorption rate is maintained at a predetermined level or more. Without intending to be bound by a particular theory, an optimal shell thickness range may be satisfied by limiting optical density per unit weight of quantum dots to a specific range.

Table 2

| | Weight ratio of element to the weight of Ti in the quantum dot composite | | | | | |
|---|---|---|---|---|---|---|
| | P/Ti | S/Ti | Zn/Ti | Se/Ti | In/Ti | Ti |
| Example 1 | 0.15 | 4.77 | 14.19 | 9.04 | 0.55 | 1.00 |
| Example 2 | 0.26 | 5.99 | 12.39 | 3.12 | 1.05 | 1.00 |
| Example 3 | 0.13 | 1.28 | 3.56 | 1.64 | 0.27 | 1.00 |
| Comp. Example 1 | 0.37 | 3.72 | 12.37 | 2.35 | 1.55 | 1.00 |
| Comp. Example 2 | 0.51 | 2.25 | 12.55 | 6.71 | 2.34 | 1.00 |
| Comp. Example 3 | 0.24 | 4.14 | 13.59 | 2.75 | 0.99 | 1.00 |

As indicated in Table 2, the quantum dot composites according to Examples 1, 2, and 3 have different weight ratios of each element based on a weight of titanium element, which is derived from titanium dioxide, than the quantum dot composites according to Comparative Examples 1, 2, and 3. Accordingly, the quantum dots satisfying a specific optical density range according to an embodiment may be included in a quantum dot composites at concentrations different than conventional quantum dot composites. Accordingly, light conversion efficiency of the quantum dot composite may be improved due to the differences in concentration of quantum dots in the quantum dot composite.

Preparation Example: Manufacturing of Display Panel including a color conversion layer

Quantum dot composites prepared in Examples 1 and 2 including the green quantum dots, and the quantum dot composite of Example 3 including red quantum dots, are applied to green pixels and red pixels, respectively, in a color conversion panel (layer). A film including components other than quantum dots is applied to a light transmitting layer that transmits blue light, which is excitation light, to manufacture display panels. The display panels are manufactured by varying the content of titanium dioxide included in the blue light transmitting layer in 5 wt% or 10 wt%. In addition,

the area ratios of the green pixel, the red pixel, and the light transmitting layer are changed as indicated in Tables 3 and 4, to manufacture various types of display panels including color conversion layer. The structures of the display panels manufactured by varying the area ratio of each pixel and the light transmitting layer, and the content of titanium dioxide in the light transmitting layer, are shown in Tables 3 and 4, respectively. In these display panels (or these color conversion layer), each weight ratio of indium, phosphorus, zinc, selenium, or sulfur to a weight of titanium included over each display panel is calculated, and is listed in Tables 3 and 4. In addition, the weight ratio of each element to that of Ti in each display panel listed in Tables 3 and 4 is converted to a mole ratio of each element, which is provided in Tables 5 and 6, respectively.

Table 3

| Area ratio of each pixel | | | Weight ratio of element to the weight of Ti with 5 wt% of $TiO_2$ included in the light transmitting layer | | | | | |
|---|---|---|---|---|---|---|---|---|
| Red pixel (Ex. 3) | Green pixel (Ex. 1) | Light transmitting layer (Blue) ($TiO_2$ only) | P/Ti | S/Ti | Zn/Ti | Se/Ti | In/Ti | Ti |
| 1 | 1 | 1 | 0.09 | 1.44 | 4.16 | 2.34 | 0.22 | 1.00 |
| 0.9 | 1.1 | 1 | 0.09 | 1.50 | 4.37 | 2.50 | 0.23 | 1.00 |
| 0.8 | 1.2 | 1 | 0.09 | 1.58 | 4.59 | 2.66 | 0.23 | 1.00 |
| 0.9 | 1 | 1.1 | 0.09 | 1.45 | 4.19 | 2.38 | 0.22 | 1.00 |
| 0.8 | 1 | 1.2 | 0.08 | 1.45 | 4.22 | 2.42 | 0.22 | 1.00 |
| 2 | 4 | 1 | 0.11 | 2.26 | 6.61 | 3.90 | 0.32 | 1 |
| 1 | 4 | 1 | 0.11 | 2.57 | 7.57 | 4.62 | 0.34 | 1 |
| | | | | | | | | |
| Red (Ex. 3) | Green (Ex. 2) | Blue ($TiO_2$ only) | P/Ti | S/Ti | Zn/Ti | Se/Ti | In/Ti | Ti |
| 1 | 1 | 1 | 0.11 | 1.73 | 4.00 | 1.36 | 0.32 | 1.00 |
| 0.9 | 1.1 | 1 | 0.11 | 1.83 | 4.19 | 1.38 | 0.34 | 1.00 |
| 0.8 | 1.2 | 1 | 0.12 | 1.94 | 4.38 | 1.40 | 0.36 | 1.00 |
| 0.9 | 1 | 1.1 | 0.11 | 1.75 | 4.03 | 1.34 | 0.33 | 1.00 |
| 0.8 | 1 | 1.2 | 0.11 | 1.78 | 4.05 | 1.33 | 0.33 | 1.00 |
| 2 | 4 | 1 | 0.16 | 2.80 | 6.21 | 1.91 | 0.51 | 1 |
| 1 | 4 | 1 | 0.16 | 3.26 | 7.01 | 1.99 | 0.56 | 1 |

Table 4

| Area ratio of each pixel | | | Weight ratio of element to the weight of Ti with 10 wt% of $TiO_2$ included in the light transmitting layer | | | | | |
|---|---|---|---|---|---|---|---|---|
| Red pixel (Ex. 3) | Green pixel (Ex.1) | Light transmitting layer (Blue) ($TiO_2$ only) | P/Ti | S/Ti | Zn/Ti | Se/Ti | In/Ti | Ti |
| 1 | 1 | 1 | 0.07 | 1.07 | 3.09 | 1.74 | 0.17 | 1.00 |
| 0.9 | 1.1 | 1 | 0.06 | 1.11 | 3.22 | 1.84 | 0.17 | 1.00 |
| 0.8 | 1.2 | 1 | 0.06 | 1.15 | 3.35 | 1.94 | 0.17 | 1.00 |
| 0.9 | 1 | 1.1 | 0.06 | 1.06 | 3.07 | 1.74 | 0.16 | 1.00 |
| 0.8 | 1 | 1.2 | 0.06 | 1.05 | 3.05 | 1.75 | 0.16 | 1.00 |
| 2 | 4 | 1 | 0.10 | 1.93 | 5.63 | 3.33 | 0.27 | 1 |

(continued)

| Area ratio of each pixel | | | Weight ratio of element to the weight of Ti with 10 wt% of $TiO_2$ included in the light transmitting layer | | | | | |
|---|---|---|---|---|---|---|---|---|
| Red pixel (Ex. 3) | Green pixel (Ex.1) | Light transmitting layer (Blue) ($TiO_2$ only) | P/Ti | S/Ti | Zn/Ti | Se/Ti | In/Ti | Ti |
| 1 | 4 | 1 | 0.09 | 2.09 | 6.16 | 3.76 | 0.27 | 1 |
| Red (Ex. 3) | Green (Ex. 2) | Blue ($TiO_2$ only) | P/Ti | S/Ti | Zn/Ti | Se/Ti | In/Ti | Ti/Ti |
| 1 | 1 | 1 | 0.08 | 1.29 | 2.99 | 1.01 | 0.24 | 1.00 |
| 0.9 | 1.1 | 1 | 0.08 | 1.36 | 3.10 | 1.02 | 0.25 | 1.00 |
| 0.8 | 1.2 | 1 | 0.08 | 1.43 | 3.22 | 1.03 | 0.26 | 1.00 |
| 0.9 | 1 | 1.1 | 0.08 | 1.29 | 2.97 | 0.99 | 0.24 | 1.00 |
| 0.8 | 1 | 1.2 | 0.08 | 1.29 | 2.94 | 0.97 | 0.24 | 1.00 |
| 2 | 4 | 1 | 0.13 | 2.40 | 5.32 | 1.63 | 0.44 | 1 |
| 1 | 4 | 1 | 0.14 | 2.68 | 5.76 | 1.63 | 0.48 | 1 |

Table 5

| Area ratio of each pixel | | | Mole ratio of element to moles of Ti with 5 wt% of $TiO_2$ included in the light transmitting layer | | | | | |
|---|---|---|---|---|---|---|---|---|
| Red pixel (Ex. 3) | Green pixel (Ex. 1) | Light transmitting layer (Blue) ($TiO_2$ only) | P/Ti | S/Ti | Zn/Ti | Se/Ti | In/Ti | Ti |
| 1 | 1 | 1 | 0.14 | 2.15 | 3.04 | 1.42 | 0.09 | 1.00 |
| 0.9 | 1.1 | 1 | 0.14 | 2.25 | 3.20 | 1.52 | 0.09 | 1.00 |
| 0.8 | 1.2 | 1 | 0.13 | 2.35 | 3.36 | 1.61 | 0.10 | 1.00 |
| 0.9 | 1 | 1.1 | 0.13 | 2.16 | 3.07 | 1.44 | 0.09 | 1.00 |
| 0.8 | 1 | 1.2 | 0.13 | 2.17 | 3.09 | 1.47 | 0.09 | 1.00 |
| 2 | 4 | 1 | 0.18 | 3.37 | 4.84 | 2.37 | 0.13 | 1 |
| 1 | 4 | 1 | 0.17 | 3.84 | 5.54 | 2.81 | 0.14 | 1 |
| Red (Ex. 3) | Green (Ex. 2) | Blue ($TiO_2$ only) | P | S | Zn | Se | In | Ti |
| 1 | 1 | 1 | 0.17 | 2.58 | 2.93 | 0.83 | 0.14 | 1.00 |
| 0.9 | 1.1 | 1 | 0.17 | 2.74 | 3.06 | 0.84 | 0.14 | 1.00 |
| 0.8 | 1.2 | 1 | 0.18 | 2.90 | 3.21 | 0.85 | 0.15 | 1.00 |
| 0.9 | 1 | 1.1 | 0.17 | 2.61 | 2.95 | 0.81 | 0.14 | 1.00 |
| 0.8 | 1 | 1.2 | 0.17 | 2.65 | 2.96 | 0.81 | 0.14 | 1.00 |
| 2 | 4 | 1 | 0.24 | 4.18 | 4.55 | 1.16 | 0.21 | 1 |
| 1 | 4 | 1 | 0.25 | 4.87 | 5.14 | 1.21 | 0.24 | 1 |

Table 6

| Area ratio of each pixel | | | Mole ratio of element to moles of Ti with 10 wt% of $TiO_2$ included in the light transmitting layer | | | | | |
|---|---|---|---|---|---|---|---|---|
| Red pixel (Ex. 3) | Green pixel (Ex. 1) | Light transmitting layer (Blue) ($TiO_2$ only) | P | S | Zn | Se | In | Ti |
| 1 | 1 | 1 | 0.10 | 1.59 | 2.26 | 0.61 | 0.07 | 1.00 |
| 0.9 | 1.1 | 1 | 0.10 | 1.65 | 2.35 | 0.62 | 0.07 | 1.00 |
| 0.8 | 1.2 | 1 | 0.10 | 1.72 | 2.45 | 0.63 | 0.07 | 1.00 |
| 0.9 | 1 | 1.1 | 0.10 | 1.58 | 2.25 | 0.60 | 0.07 | 1.00 |
| 0.8 | 1 | 1.2 | 0.09 | 1.57 | 2.23 | 0.59 | 0.07 | 1.00 |
| 2 | 4 | 1 | 0.21 | 3.58 | 3.90 | 0.99 | 0.18 | 1 |
| 1 | 4 | 1 | 0.21 | 3.99 | 4.21 | 0.99 | 0.20 | 1 |
| Red (Ex. 3) | Green (Ex. 2) | Blue ($TiO_2$ only) | P | S | Zn | Se | In | Ti |
| 1 | 1 | 1 | 0.13 | 1.93 | 2.19 | 0.61 | 0.10 | 1.00 |
| 0.9 | 1.1 | 1 | 0.13 | 2.03 | 2.27 | 0.61 | 0.11 | 1.00 |
| 0.8 | 1.2 | 1 | 0.13 | 2.13 | 2.36 | 0.61 | 0.11 | 1.00 |
| 0.9 | 1 | 1.1 | 0.13 | 1.93 | 2.17 | 0.61 | 0.10 | 1.00 |
| 0.8 | 1 | 1.2 | 0.12 | 1.93 | 2.15 | 0.61 | 0.10 | 1.00 |
| 2 | 4 | 1 | 0.12 | 1.93 | 2.19 | 0.61 | 0.10 | 1 |
| 1 | 4 | 1 | 0.12 | 1.93 | 2.19 | 0.61 | 0.10 | 1 |

Referring to Tables 3 to 6, since the quantum dot composites according to Examples 1 to 3 that have quantum dots with a weight ratio, or a mole ratio, of each listed element within a specific range, the ratios of weights or ratios of moles among the elements are also in a specific range over the entire display panel manufactured with the respective quantum dot composite. Accordingly, when a quantum dot composite including the quantum dots satisfying this specific range or a display panel including the quantum dot composite is included, an absorption rate of blue light increases as well as light conversion efficiency is shown to improve, and therefore, a display device will have excellent luminous efficiency.

A method of measuring a content of each element in each display panel, which is described in Tables 3 to 6, is performed by physically scraping off a solid of a portion corresponding to a predetermined area or a predetermined volume, including a red pixel, a green pixel, and a light transmitting layer in each display panel. The scrapings are made into powder that is then dissolved in an acid of various types, for example, nitric acid, bromic acid, or hydrofluoric acid, to provide a solution. An ICP analysis on the solution in then conducted. The pixels and light transmitting layer include various components such as, quantum dots, titanium dioxide, a polymer forming a polymer matrix, a polymer forming the light transmitting layer, a material forming a barrier rib, that is, a black matrix, and the like. However, because the titanium is derived from titanium dioxide and the indium, phosphorus, selenium, sulfur, and zinc are derived from the quantum dots, the presence of the other components included in each pixel and the light transmitting layer, which are not derived from the quantum dots or the titanium dioxide particles, is completely independent of the weight ratio or mole ratio of each element to the weight or moles of titanium listed in Tables 3 to 6. Accordingly, the relative contents of indium, phosphorus, zinc, selenium, and sulfur elements derived from the quantum dots to that of titanium in the color conversion layer or the (entire) display panel according to an embodiment may be quantitatively analyzed.

While this disclosure has been described in connection with what is presently considered to be practical embodiments, it is to be understood that the invention is not limited to the disclosed embodiments. On the contrary, it is intended to cover various modifications and equivalent arrangements included within the scope of the appended claims.

## Claims

1. A display panel comprising a quantum dot composite,

   wherein the quantum dot composite comprises a matrix, and a plurality of quantum dots dispersed in the matrix,
   wherein the plurality of quantum dots comprises indium, zinc, phosphorus, and selenium, and optionally sulfur, and does not include cadmium,
   wherein the plurality of quantum dots comprises first quantum dots and second quantum dots, and
   wherein the first quantum dots have an optical density per 1 mg at a wavelength of 450 nm in a range of 0.2 to 0.27, and an emission peak of from 500 nm to 550 nm, and
   wherein the second quantum dots have an optical density per 1 mg at a wavelength of 450 nm in a range of 0.5 to 0.7, and an emission peak of from 610 nm to 660 nm.

2. The display panel of claim 1, wherein the first quantum dots have an optical density per 1 mg at a wavelength at 460 nm in a range of 0.12 to 0.35, and/or an emission peak of from 530 nm to 540 nm;
   and/or
   wherein the second quantum dots have an optical density per 1 mg for a wavelength at 460 nm in a range of 0.4 to 0.5, and/or an emission peak of from 635 nm to 645 nm.

3. The display panel of any of claims 1 or 2, wherein the plurality of quantum dots comprises a semiconductor nanocrystal core comprising indium and phosphorus, and a semiconductor nanocrystal shell disposed on the semiconductor nanocrystal core, the nanocrystal shell comprising zinc and selenium; preferably wherein the semiconductor nanocrystal shell further comprises sulfur; and/or
   wherein the matrix comprises a polymerizable monomer having a carbon-carbon double bond, an organic solvent, a polymer, a thiol compound having at least one thiol group, or a combination thereof.

4. The display panel of claim 3, wherein the semiconductor nanocrystal shell comprises a first semiconductor nanocrystal shell disposed on the semiconductor nanocrystal core, the first nanocrystal shell comprising zinc and selenium, and optionally sulfur, and a second semiconductor nanocrystal shell disposed on the first semiconductor nanocrystal shell, the second nanocrystal shell comprising zinc and sulfur, and optionally selenium.

5. The display panel of any of claims 1 to 4, wherein in the first quantum dots, the second quantum dots, or the first and second quantum dots, a weight ratio of zinc to indium (Zn/In) is greater than or equal to 10 and less than or equal to 30, and a weight ratio of selenium to indium (Se/In) is greater than or equal to 2.9 and less than or equal to 20.

6. The display panel of any of claims 1-5, wherein the display panel comprises a color conversion layer comprising a plurality of regions including a color conversion region, and the quantum dot composite is disposed in the color conversion region; preferably wherein the plurality of regions of the color conversion layer further comprise a light transmitting region configured to transmit blue light and/or green light emitted from the light emitting panel,

   and/or
   wherein the display panel further comprises a light emitting panel including a light emitting source configured to emit blue light, a light emitting source configured to emit green light, or a combination thereof, and/or
   wherein the color conversion layer comprises a first color conversion region configured to convert blue light and/or green light emitted from the light emitting panel into light of a first emission spectrum, a second color conversion region configured to convert blue light and/or green light emitted from the light emitting panel into light of a second emission spectrum, or a combination thereof;
   preferably wherein the first emission spectrum is a green emission spectrum having an emission peak wavelength of from 500 nm to 550 nm and/or wherein the second emission spectrum is a red emission spectrum having an emission peak wavelength of from 610 nm to 660 nm.

7. A display panel comprising a quantum dot composite,

   the quantum dot composite comprising a matrix, and a plurality of quantum dots and titanium dioxide dispersed in the matrix,
   wherein the plurality of quantum dots comprises indium, zinc, phosphorus, and selenium, and
   wherein the display panel has a weight ratio of indium to titanium (In/Ti) that is greater than or equal to 0.1 and less than or equal to 0.7, and a weight ratio of phosphorus to titanium (P/Ti) that is greater than or equal to 0.05

and less than or equal to 0.2.

8. The display panel of claim 7, wherein the display panel comprises a color conversion layer comprising a plurality of regions including a color conversion region, and the quantum dot composite is disposed in the color conversion region; preferably wherein the plurality of regions of the color conversion layer further comprise a light transmitting region configured to transmit blue light and/or green light emitted from the light emitting panel,

   and/or
   wherein the display panel further comprises a light emitting panel including a light emitting source configured to emit blue light, a light emitting source configured to emit green light, or a combination thereof, and/or
   wherein the color conversion layer comprises a first color conversion region configured to convert blue light and/or green light emitted from the light emitting panel into light of a first emission spectrum, a second color conversion region configured to convert blue light and/or green light emitted from the light emitting panel into light of a second emission spectrum, or a combination thereof.

9. The display panel of any of claims 7-8, wherein the first emission spectrum is a green emission spectrum having an emission peak wavelength of from 500 nm to 550 nm, and
   wherein in the first color conversion region, a weight ratio of selenium to titanium (Se/Ti) is greater than or equal to 2 and less than or equal to 12; and/or wherein in the first color conversion region, a weight ratio of indium to titanium (In/Ti) is greater than or equal to 0.2 and less than or equal to 1.8, and a weight ratio of phosphorus to titanium (P/Ti) is greater than or equal to 0.05 and less than or equal to 0.4.

10. The display panel of any of claims 7-9, wherein the second emission spectrum is a red emission spectrum having an emission peak wavelength of from 610 nm to 660 nm, and
    wherein in the second color conversion region, a weight ratio of selenium to titanium (Se/Ti) is greater than or equal to 1 and less than or equal to 5; and/or wherein in the second color conversion region, a weight ratio of indium to titanium (In/Ti) is greater than or equal to 0.1 and less than or equal to 0.5, and a weight ratio of phosphorus to titanium (P/Ti) is greater than or equal to 0.05 and less than or equal to 0.2.

11. The display panel of any of claims 8-10, wherein in the first color conversion region, a weight ratio of In to titanium (In/Ti) is greater than or equal to 0.2 and less than or equal to 1.5, a weight ratio of phosphorus to titanium (P/Ti) is greater than or equal to 0.1 and less than or equal to 0.3, and/or a weight ratio of selenium to titanium (Se/Ti) is greater than or equal to 3 and less than or equal to 10.

12. The display panel of any of claims 8-11, wherein in the second color conversion region, a weight ratio of indium to titanium (In/Ti) is greater than or equal to 0.2 and less than or equal to 0.4, a weight ratio of phosphorus to titanium (P/Ti) is greater than or equal to 0.1 and less than or equal to 0.3, and/or a weight ratio of selenium to titanium (Se/Ti) is greater than or equal to 1.2 and less than or equal to 3.

13. The display panel of any of claims 7-12, wherein the plurality of quantum dots comprises a semiconductor nanocrystal core comprising indium and phosphorus, and a semiconductor nanocrystal shell disposed on the semiconductor nanocrystal core, the nanocrystal shell comprising zinc and selenium, and optionally, sulfur, and/or
    wherein the matrix comprises a polymerizable monomer having a carbon-carbon double bond, an organic solvent, a polymer, a thiol compound having at least one thiol group, or a combination thereof.

14. The display panel of any of claims 7-13, wherein the display panel has a weight ratio of selenium to titanium (Se/Ti) that is greater than or equal to 0.5 and less than or equal to 5, preferably greater than or equal to 0.5 and less than or equal to 3.

15. An electronic device comprising the display panel of any of claims 1 to 14.

FIG. 1A

Pattern Preparation by using a photoresist

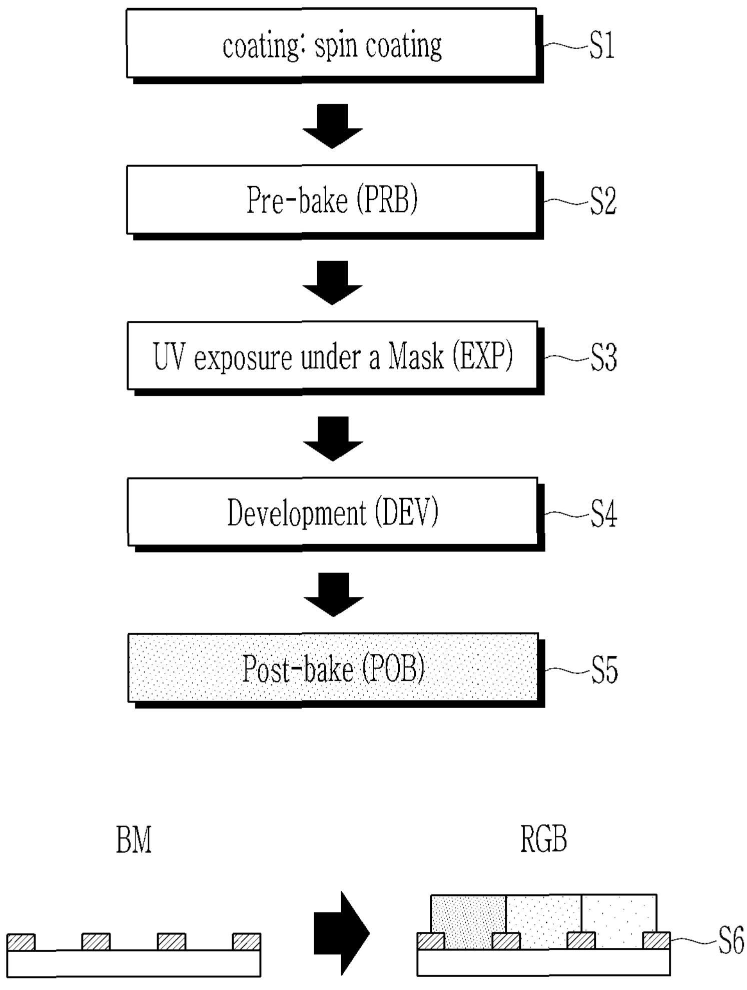


Repeating the Patterning Process three times

FIG. 1B

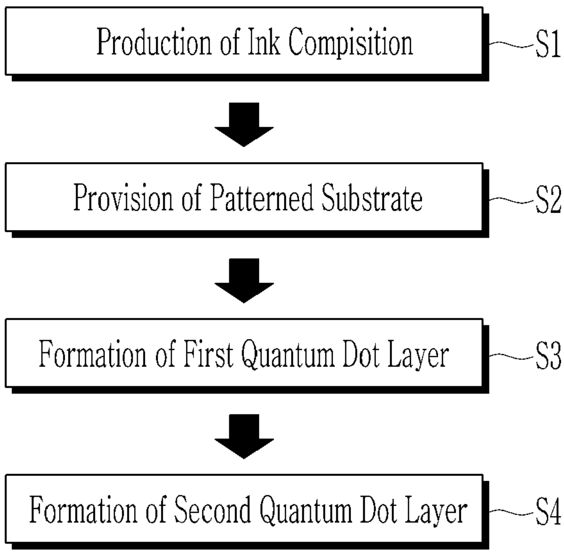
Production of Ink Compisition
S1
Provision of Patterned Substrate
S2
Formation of First Quantum Dot Layer
S3
Formation of Second Quantum Dot Layer
S4

FIG. 2

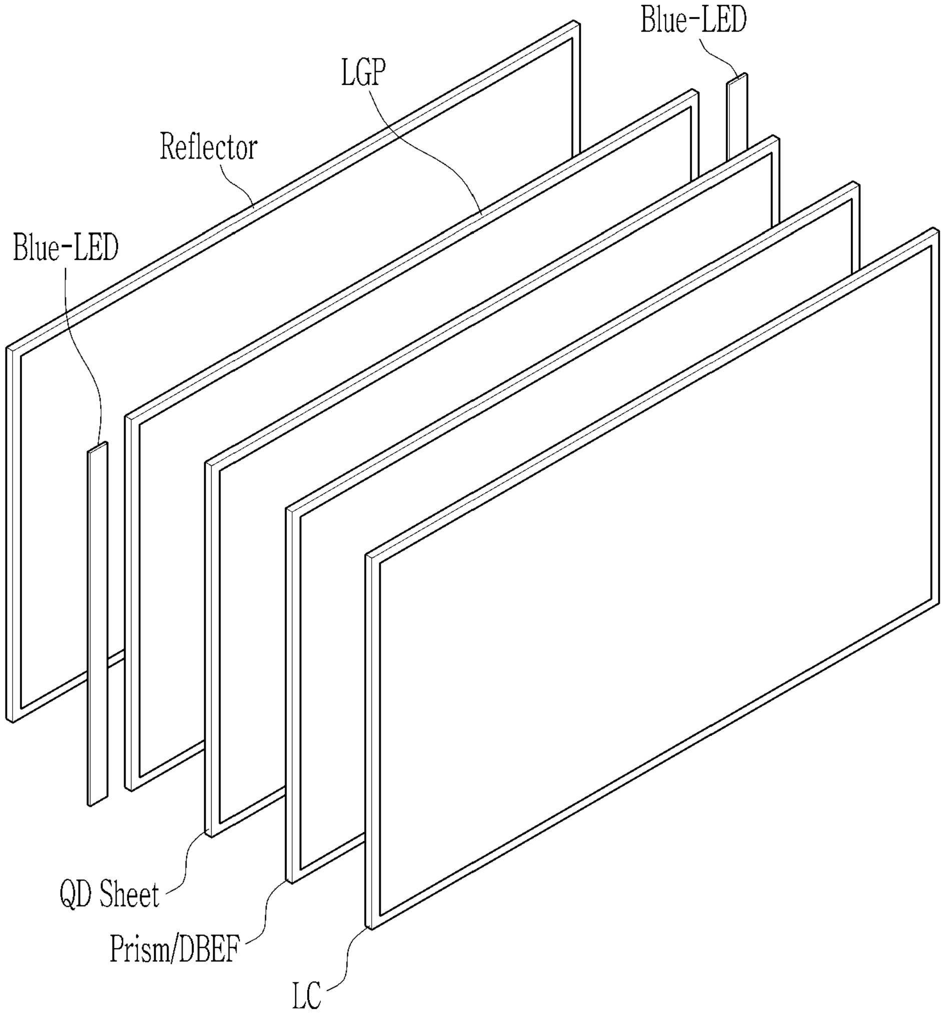

FIG. 3

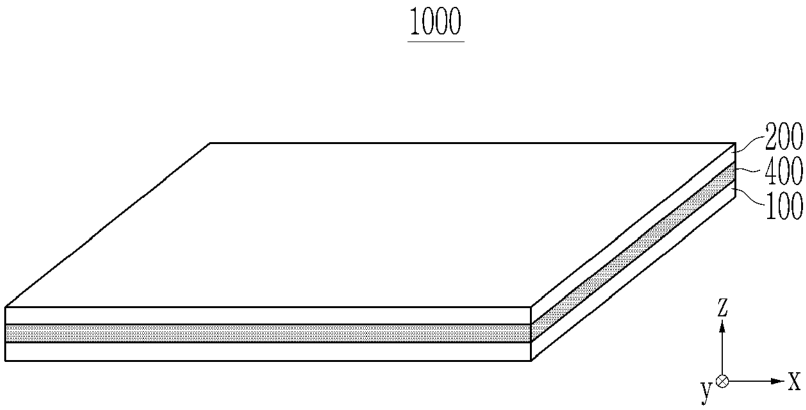

FIG. 4

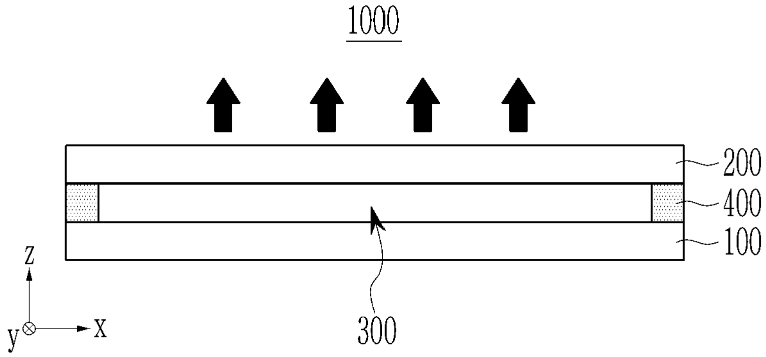

FIG. 5

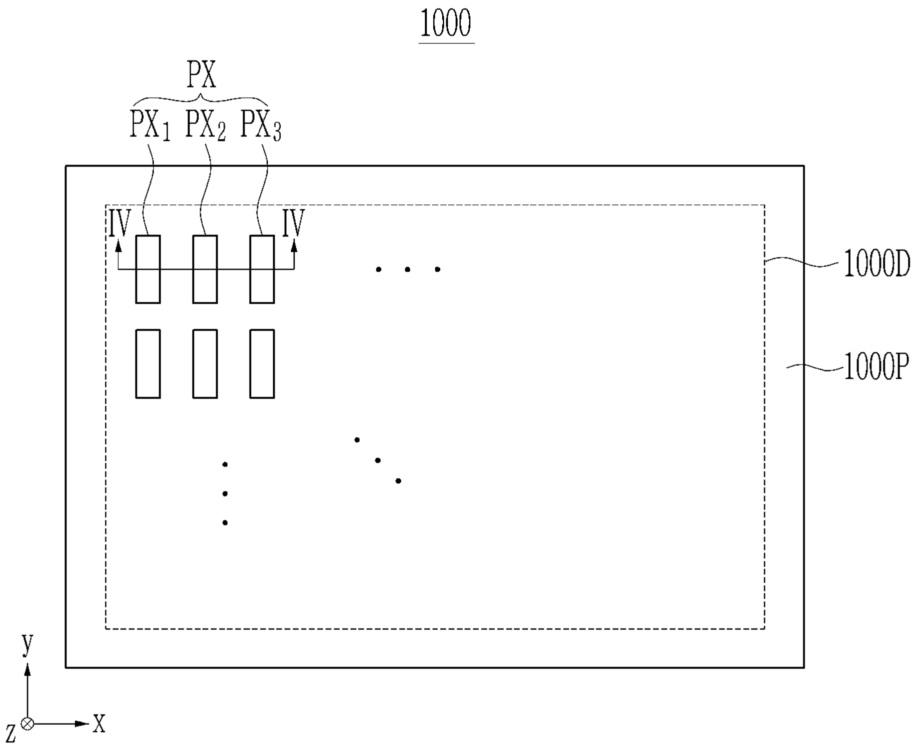

FIG. 6A

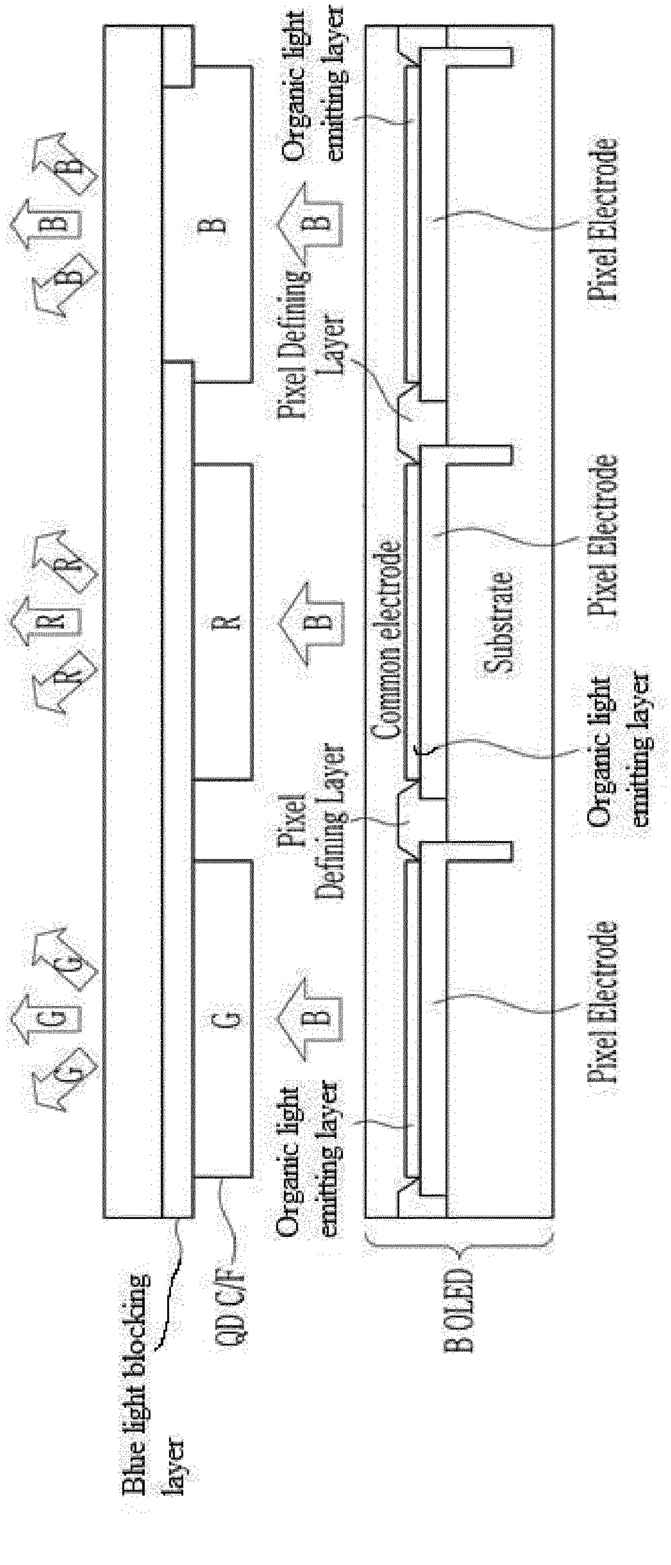
Blue light blocking layer
QD C/F
B OLED
G
R
B
Organic light emitting layer
Pixel Defining Layer
Common electrode
Substrate
Pixel Electrode

FIG. 6B

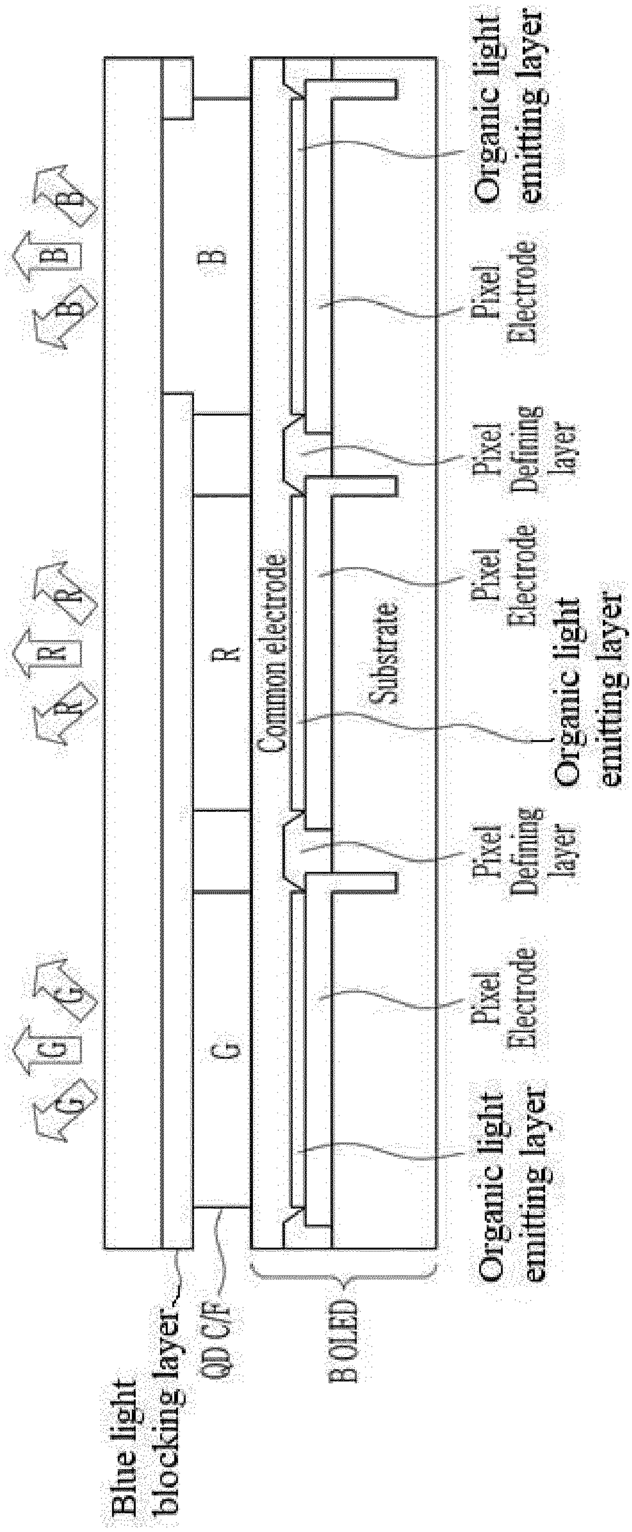

G
G
G
R
R
R
B
B
B
G
R
B
Common electrode
Substrate
Blue light blocking layer
QD C/F
B OLED
Organic light emitting layer
Pixel Electrode
Pixel Defining layer
Pixel Electrode
Organic light emitting layer
Pixel Defining layer
Pixel Electrode
Organic light emitting layer

FIG. 7

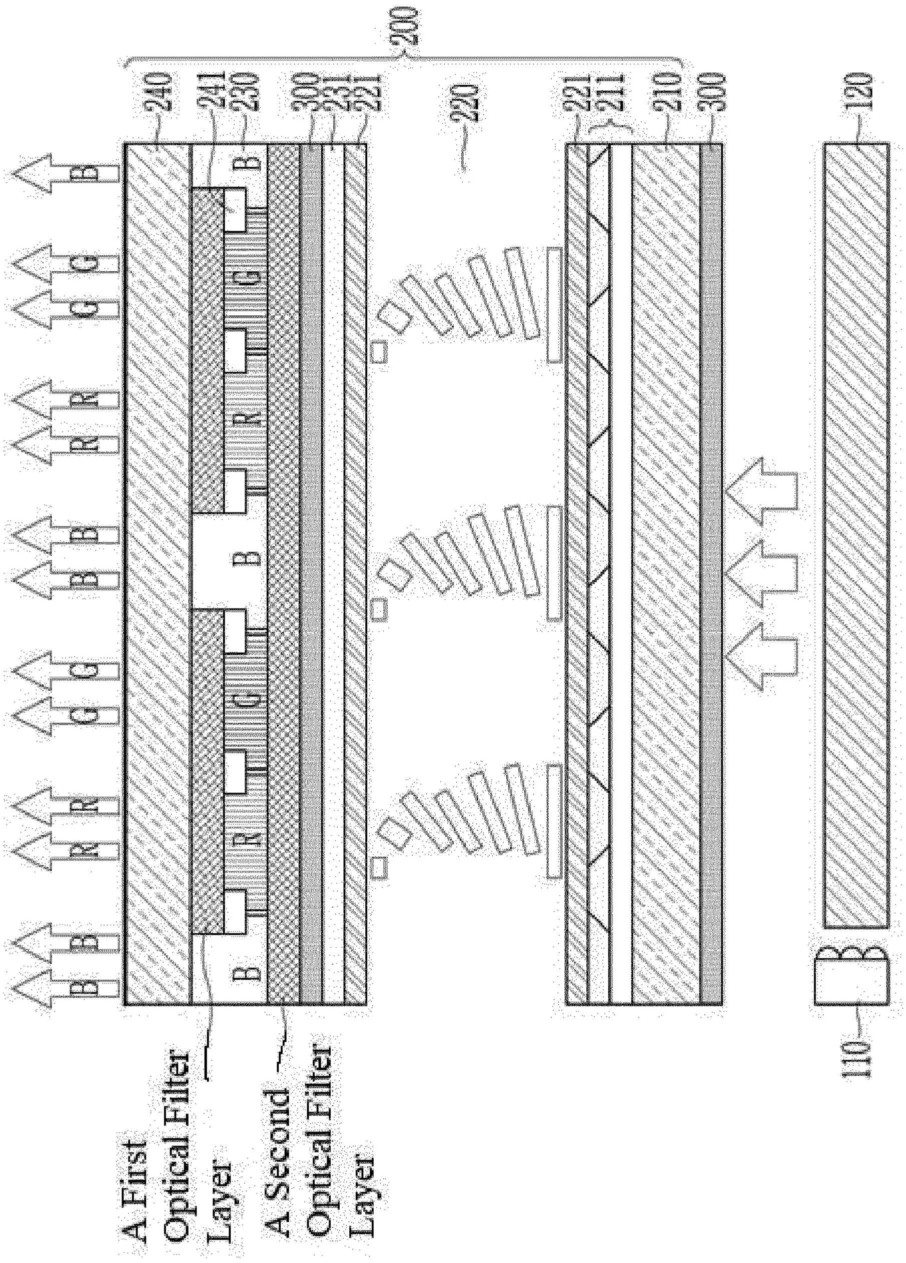
200
240
241
230
300
231
221
220
221
211
210
300
120
110
B
G
R
A First Optical Filter Layer
A Second Optical Filter Layer

FIG. 8

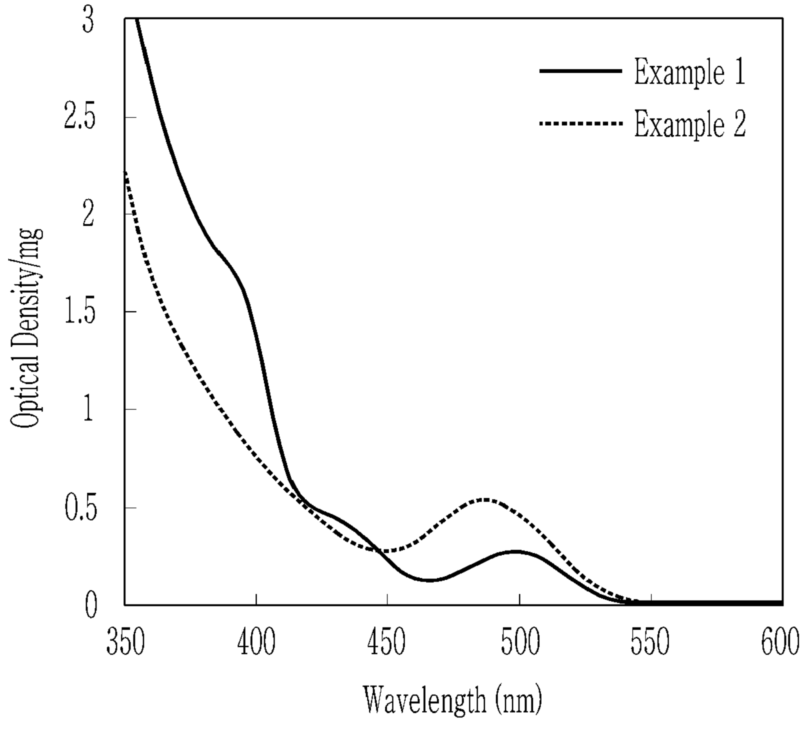

3
2.5
2
1.5
1
0.5
0
Optical Density/mg
350
400
450
500
550
600
Wavelength (nm)
Example 1
Example 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20170052444 A1